# EUROPÄISCHE PATENTSCHRIFT

(11) **EP 1 757 612 B1**
(45) Veröffentlichungstag und Bekanntmachung des Hinweises auf die Patenterteilung: **08.10.2008**
(21) Anmeldenummer: 06014019.1
(22) Anmeldetag: 06.07.2006
(51) Int. Cl.: C07F 9/00, C23C 16/18, C23C 16/34

(54) **Tantal- und Niob- Verbindungen und ihre Verwendung für die Chemical Vapour Deposition (CVD)**
Tantalum- and Niobium- compounds and their use in Chemical Vapour deposition (CVD)
Composés à base de tantale et de niobium utilisées pour des procèdes de dépôt en phase gazeuse par procède chimique

(30) Priorität: 15.07.2005 DE 102005033102
(43) Veröffentlichungstag der Anmeldung: 28.02.2007
(73) Patentinhaber: H.C. Starck GmbH, 38642 Goslar (DE)
(72) Erfinder: Reuter, Knud, Dr., 47800 Krefeld (DE); Sundermeyer, Jörg, Prof. Dr., 35041 Marburg (DE); Merkoulov, Alexei, 127322 Moskau (RU); Stolz, Wolfgang, Dr., 35041 Marburg (DE); Kerstin, Volz, 35232 Dautphetal (DE); Pokoj, Michael, 35463 Fernwald (DE); Ochs, Thomas, 35274 Kirchheim-Betziesdorf (DE)
(74) Vertreter: Clauswitz, Kai-Uwe Wolfram

(56) Entgegenhaltungen:
- US-B2- 6 593 484

## Beschreibung

Die vorliegende Erfindung betrifft spezielle, neue Tantal- und Niobverbindungen, deren Verwendung zur Abscheidung tantal- bzw. niobhaltiger Schichten mittels Chemical Vapor Deposition sowie die gemäß diesem Verfahren hergestellten tantal- bzw. niobhaltigen Schichten.

Ta- sowie Ta-N-basierende Mischsystemschichten für die Anwendung in der Si-Mikroelektronik werden gegenwärtig durch plasmabasierende Abscheideverfahren (Physical Vapour Deposition PVD) hergestellt. Im Hinblick auf die extremen Anforderungen für immer höher integrierte Schaltkreise, z.B. der konformen Schichtabscheidung auf strukturierten Oberflächen, gelangen die PVD-Verfahren zunehmend an die Grenzen der technischen Realisierbarkeit. Für diese Anwendungen werden verstärkt chemische Gasphasenabscheidungen (Chemical Vapour Deposition CVD) bis hin zur atomlagen-genauen Abscheidung mit einem Spezialverfahren der CVD, der sogenannten Atomic Layer Deposition (ALD), eingesetzt. Für diese CVD-Verfahren müssen naturgemäß für die jeweiligen gewünschten Schichten entsprechende chemische Ausgangsstoffe der einzelnen Elemente zur Verfügung stehen.

Zum gegenwärtigen Zeitpunkt werden für die CVD Ta-basierender Schichtstrukturen vorwiegend Halogenide, wie z.B. TaCl₅, TaBr₅, siehe WO 2000065123 Al, A. E. Kaloyeros et al., J. Electrochem. Soc. 146 (1999), S. 170-176, oder K. Hieber, Thin Solid Films 24 (1974), S.157-164) eingesetzt. Dies ist mit verschiedenen Nachteilen behaftet. Zum einen sind Halogenradikale vielfach aufgrund ihrer ätzenden/korrodierenden Eigenschaften für den Aufbau komplexer Schichtstrukturen unerwünscht, andererseits haben die Tantalhalogenide Nachteile durch ihre geringe Flüchtigkeit und die schwierige Verarbeitbarkeit als hochschmelzende Feststoffe. Einfache Tantal-V-amide, wie z.B. ((CH₃)₂N)₅Ta, werden ebenfalls vorgeschlagen, siehe z.B. Fix et. al., Chem. Mater., 5 (1993), S. 614-619. Mit den einfachen Amiden lassen sich aber meist nur bestimmte Zerlegungsverhältnisse von Ta zu N einstellen, die eine genaue Kontrolle der einzelnen Elementkonzentrationen in den Schichten erschweren. Vielfach bilden sich Ta -V-Nitridfilme (siehe z.B. Fix et al.: Ta₃N₅) und nicht die angestrebten elektrisch leitfähigen Ta-III-Nitrid-schichten (TaN). Zudem zeigen die mit diesen Ausgangsstoffen hergestellten Filme sehr oft hohe, unerwünschte Konzentrationen an Kohlenstoff. Tsai et. al., Appl. Phys. Lett. 67(8), (1995), S. 1128-1130 schlugen deshalb t-BuN=Ta(NEt₂)₃⁻ in TaN-CVD bei 600°C vor. Diese Verbindung bedarf wegen ihrer relativ geringen Flüchtigkeit einer hohen Anlagentemperatur und ist deshalb nicht sehr gut kompatibel mit den typischen Herstellungsprozessen integrierter Schaltkreise. Auch andere, ähnliche Tantalamidimide wurden vorgeschlagen, siehe z.B. Chiu et. al., J. Mat. Sci. Lett. 11 (1992), S. 96-98, womit jedoch ohne weiteres Reaktivgas hohe Kohlenstoffgehalte in den Tantalnitridschichten erzeugt wurden. In jüngerer Zeit wurden weitere Tantalnitrid-Prekursoren vorgeschlagen, z.B. durch Bleau et al., Polyhedron 24(3), (2005), S. 463-468, die wegen ihrer Komplexität und aufwändigen Herstellung von vornherein Nachteile aufweisen, oder spezielle Cyclopentadienylverbindungen, die entweder zwangsläufig zu TaSiN (nicht Tantalnitrid) führen oder einer zusätzlichen, nicht näher spezifizierten Stickstoffquelle bedürfen (Kamepalli et al., US Pat. Appl. Publ. 2004142555 A1, Prior. 2003-01-16, ATMI, Inc.). In US 6 593 484 (Kojundo Chemicals Laboratory Co., Ltd., Japan) wird ein geeignetes spezielles Tantalamidimid vorgeschlagen, wobei die angegebene Synthese jedoch schwierig und schlecht reproduzierbar ist.

Somit ist ein erheblicher Bedarf nach weiteren, neuen Prekursoren für TaN-Schichten erkennbar, die die vorgenannten Nachteile nicht haben oder mindestens deutliche Verbesserungen bewirken.

Somit bestand die Aufgabe, die der vorliegenden Erfindung zugrunde lag, darin, solche Precursoren bereitzustellen.

Die Erfindung betrifft komplexe Tantalamide mit einem DAD-Liganden, die diese Voraussetzungen erfüllen. DAD steht für vom 1,4-Diaza-butadien abgeleitete Reste der allgemeinen Struktur (A) 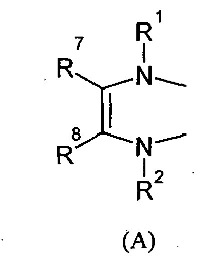 wobei
R¹ und R² unabhängig voneinander gegebenenfalls substituierte C₁- bis C₁₂-Alkyl-, C₅- bis C₁₂-Cycloalkyl-, C₆- bis C₁₀-Aryl-Reste, 1-Alkenyl-, 2-Alkenyl-, 3-Alkenyl, Triorganosilylreste -SiR₃ oder Aminoreste NR₂ worin R für einen C₁- bis C₄-Alkylrest steht, R⁷ und R⁸ unabhängig voneinander H, gegebenenfalls substituierte C₁-bis C₁₂-Alkyl-, C₅- bis C₁₂-Cycloalkyl- oder C₆- bis C₁₀-Aryl-Reste bedeuten.

Die Erfindung betrifft weiterhin die analogen Niob-Verbindungen, welche sich z.B. als CVD-Prekursoren für leitfähige Niob-Nitrid-Schichten (NbN) eignen.

Gegenstand der Erfindung sind Verbindungen der allgemeinen Formel (I), 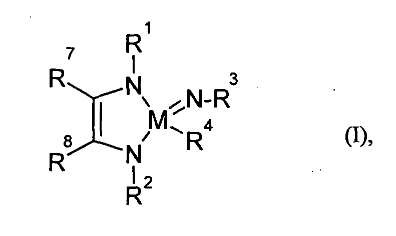 wobei
- M: für Nb oder Ta steht,
- R¹ und R²: unabhängig voneinander gegebenenfalls substituierte C₁- bis C₁₂-Alkyl-, C₅- bis C₁₂-Cycloalkyl-, C₆- bis C₁₀-Aryl-Reste, 1-Alkenyl-, 2-Alkenyl-, 3-Alkenyl,Triorganosilylreste -SiR₃ oder Aminoreste NR₂ worin R für einen C₁- bis C₄-Alkylrest steht,
- R³: einen gegebenenfalls substituierten C₁- bis C₈-Allcyl-, C₅- bis C₁₀-Cycloalkyl-, C₆- bis C₁₄-Aryl-Rest, SiR₃ oder NR₂, wobei R die oben genannte Bedeutung hat,
- R⁴: Halogen aus der Gruppe Cl, Br, I, oder NH-R⁵ mit R⁵ = gegebenenfalls substituierter C₁-bis C₈-Alkyl-, C₅- bis C₁₀-Cycloalkyl- oder C₆- bis C₁₀-Aryl-Rest, oder O-R⁶ mit R⁶ = gegebenenfalls substituierter C₁- bis C₁₁-Alkyl-, C₅- bis C₁₀-Cycloalkyl-, C₆- bis C₁₀-Aryl-Rest, oder -SiR₃, oder BH₄, oder ein gegebenenfalls substituierter Allyl-Rest, oder ein Indenyl-Rest, oder ein gegebenenfalls substituierter Benzyl-Rest, oder ein gegebenenfalls substituierter Cyclopentadienyl-Rest, oder -NR-NR'R" (Hydrazido(-1), wobei R, R' und R" unabhängig voneinander die genannte Bedeutung von R haben oder CH₂SiMe₃, Pseudohalogenid (z.B. -N₃), oder Silylamid ―N(SiMe₃)₂,
- R⁷ und R⁸: unabhängig voneinander H, gegebenenfalls substituierte C₁- bis C₁₂-Alkyl-, C₅- bis C₁₂-Cycloalkyl- oder C₆- bis C₁₀-Aryl-Reste bedeuten.

Unter substituiert wird hier, wenn nicht anders erwähnt, eine Substitution mit C₁ bis C₄ - Alkoxy- oder Di (C₁ bis C₄ - Alkyl) amino-Resten verstanden.

Aus den erfmdungsgemäßen Tantal- und Niobverbindungen können Tantal- und/oder Niob-haltige Metalle, Metalllegierungen, Oxide, Nitride und Carbide, sowie deren Mischungen und/oder Verbindungen in amorpher und/oder kristalliner Form, mittels CVD, ALD (Atomic Layer Deposition) und thermischer Zersetzung erzeugt werden. Anwendung finden derartige Mischungen und Verbindungen z.B. als dielektrische Schichten in Kondensatoren und Gates in Transistoren, Mikrowellenkeramiken, Piezokeramiken, thermische und chemische Barriereschichten, Diffusionsbarriereschichten, Hartstoffbeschichtungen, elektrisch leitfähigen Schichten, Antireflektionsschichten, optische Schichten und Schichten für IR-Spiegel. Ein Beispiel für optische Materialien sind Li-Tantalate und -Niobate. Beispiele für elektrisch leitfähige und korrosionsbeständige Schichten für Elektroden sind Tantal- und/oder Niob-haltige Titan- und Ruthenium-Mischoxide. Auch als Prekursoren für Flammpyrolysen zur Herstellung von Pulvern sind die erfindungsgemäßen Tantal- und Niobverbindungen geeignet.

Bevorzugt sind Tantal- und Niobimide der allgemeinen Formel (II), 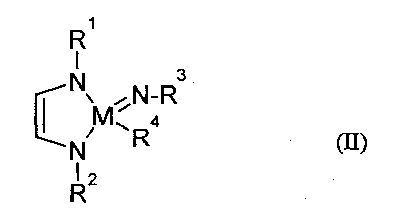 wobei
- M: für Ta oder Nb steht,
- R¹ und R²: gleiche C₁- bis C₅-Alkyl- oder C₅- bis C₆-Cycloalkyl-Reste,
- R³: einen C₁- bis C₅-Alkyl-, C₅- bis C₆-Cycloalkyl- oder gegebenenfalls substituierten Phenyl-Rest, oder SiR₃, oder NR₂, wobei R für C₁-C₄-Alkyl steht,
- R⁴: ein Halogen aus der Gruppe Cl, Br, J, einen Rest NH-R⁵ mit R⁵ = C₁- bis C₅-Alkyl-, C₅- bis C₆-Cycloalkyl- oder gegebenenfalls substituierten C₆- bis C₁₀-Aryl-Rest, oder BH₄, oder einen gegebenenfalls substituierter Allyl-Rest, oder einen Indenyl-Rest, oder einen ggf. substituierten Benzyl-Rest, oder einen gegebenenfalls substituierten Cyclopentadienyl-Rest oder einen Oxyalkyl-Rest bedeuten.

Besonders bevorzugt werden dabei Tantalamidimide mit tert.Butyl-substituierten DAD-Liganden, welche die

Struktur (III) aufweisen: 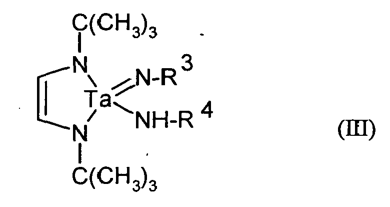 wobei
R³ und R⁴ unabhängig voneinander einen gleichen oder verschiedenen Rest aus der Gruppe der C₁- bis C₅-Alkyl-Reste bzw. gegebenenfalls durch eine bis drei C₁ bis C₅-Alkylgruppen substituierten, C₆- C₁₀-Arylreste oder SiR₃, oder NR₂ bedeuten.

Ganz besonders bevorzugt ist die Verbindung der Struktur (IV)

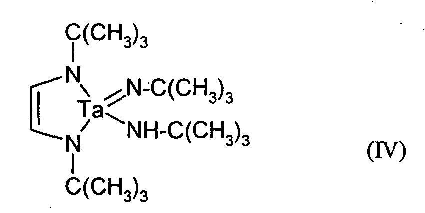

Ebenso ganz besonders bevorzugt sind die analogen Verbindungen der Formel (V) 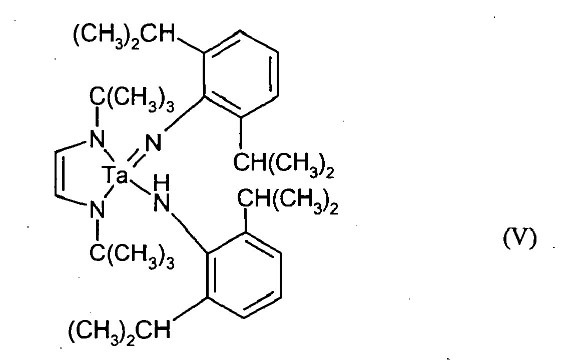 und die analoge Verbindung der Struktur (VI), die insbesondere gewöhnlich in dimerer Form vorliegt,

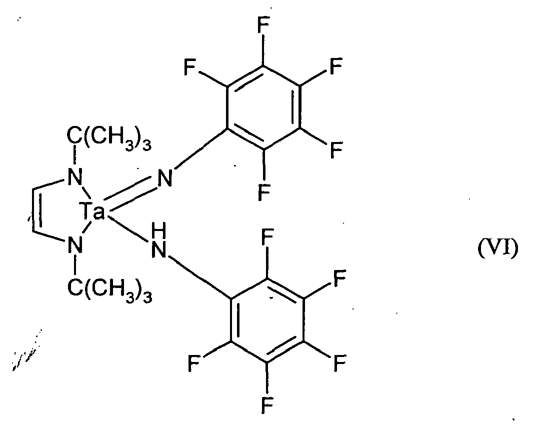

Weitere ganz besonders bevorzugte Verbindungen sind solche der Struktur (VII), 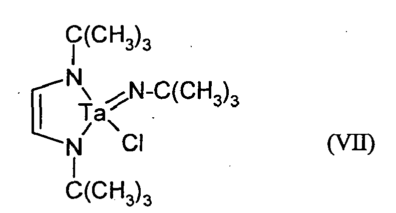 der Struktur (VIII), 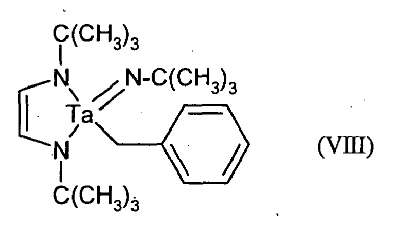 der Struktur (IX), 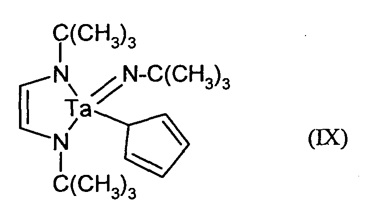 und der Struktur (X).

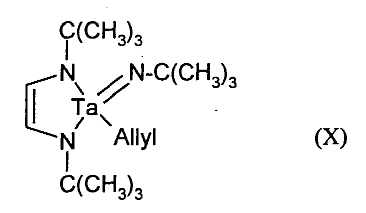

Besonders bevorzugte Verbindungen sind weiterhin solche der allgemeinen Formel (XI), 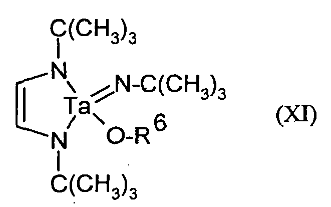 wobei
R⁶ einen gegebenenfalls substituierten C₁- bis C₁₂-Alkyl-Rest bedeutet.

Aus dieser Gruppe wird besonders bevorzugt die Verbindung der Struktur (XII).

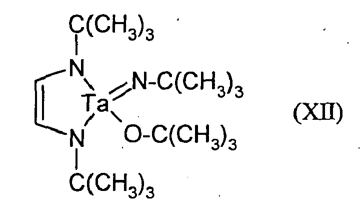

Weiterhin sind bevorzugte Verbindungen diejenigen der allgemeinen Struktur (XIII), 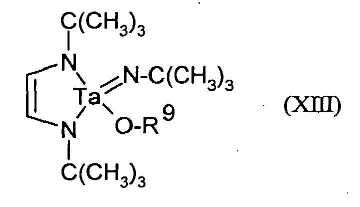 wobei
R⁹ einen Rest eines Enolats der Formel (XIV), 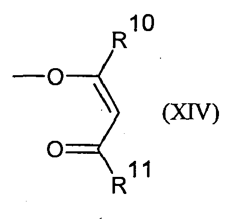 in dem
R¹⁰ einen C¹- bis C⁴-Alkylrest bedeutet und R¹¹ gleich R¹⁰ oder unabhängig voneinander OR¹⁰ ist, bedeutet.

**Alkyl** beziehungsweise **Alkoxy** steht jeweils unabhängig für einen geradkettigen, cyclischen oder verzweigten Alkyl- beziehungsweise Alkoxy-Rest, wobei die genannten Reste gegebenenfalls weiter substituiert sein können. Gleiches gilt für den Alkylteil eines Trialkylsilyl- bzw. Mono- oder Dialkylaminorestes oder den Alkylteil von Mono- oder Dialkylhydrazinen oder Mono-, Di-, Tri-oder Tetraalkylsilanen.

**C₁-C₄-Alkyl** steht im Rahmen der Erfindung beispielsweise für Methyl, Ethyl, n-Propyl, isoPropyl, n-Butyl, sec.-Butyl, tert.-Butyl, **C₁-C₅-Alkyl** darüber hinaus beispielsweise für n-Pentyl, 1-Methylbutyl, 2-Methylbutyl, 3-Methylbutyl, neo-Pentyl (2,2-Dimethylpropyl), 1-Ethylpropyl, 1,1-Dimethylpropyl, 1,2-Dimethylpropyl, 1,2-Dimethylpropyl, **C₁-C₆-Alkyl** darüber hinaus beispielsweise für n-Hexyl, 1-Methylpentyl, 2-Methylpentyl, 3-Methylpentyl, 4-Methylpentyl, 1,1-Dimethylbutyl, 1,2-Dimethylbutyl, 1,3-Dimethylbutyl, 2,2-Dimethylbutyl, 2,3-Dimethylbutyl, 3,3-Dimethylbutyl, -1-Ethylbutyl, 2-Ethylbutyl, 1,1,2-Trimethylpropyl, 1,2,2-Trimethylpropyl, 1-Ethyl-1-methylpropyl, 1-Ethyl-2-methylpropyl oder 1-Ethyl-2-methylpropyl, **C₁-C₁₂-Alkyl** darüber hinaus beispielsweise für n-Heptyl und n-Octyl, n-Nonyl, n-Decyl und n-Dodecyl.

**1-Alkenyl, 2-Alkenyl, 3-Alkenyl** steht beispielsweise für die den vorangehenden Alkylgruppen entsprechenden Alkenylgruppen. **C₁-C₄-Alkoxy** steht beispielsweise für die den vorangehenden Alkylgruppen entsprechenden Alkoxygruppen, wie z.B. Methoxy, Ethoxy, n-Propoxy, iso-Propoxy, n-Butoxy, sec.-Butoxy, tert.-Butoxy.

**C₅-C₁₂-Cycloalkyl** steht beispielsweise für gegebenenfalls substituierte niono-, bi- oder tricylische Alkylreste. Als Beispiele seien Cylopentyl, Cyclohexyl, Cycloheptyl, Pinanyl, Adamantyl, die isomeren Menthyle, n-Nonyl, n-Decyl, n-Dodecyl. Bevorzugt als **C₅-C₆-Cycloalkyl** sind Cylopentyl und Cyclohexyl.

**Aryl** steht jeweils unabhängig für einen aromatischen Rest mit 6 bis 14, bevorzugt 6 bis 10 Gerüstkohlenstoffatomen, in denen keines, ein, zwei oder drei Gerüstkohlenstoffatome pro Cyclus durch Heteroatome, ausgewählt aus der Gruppe Stickstoff, Schwefel oder Sauerstoff, ersetzt sein können, vorzugsweise jedoch für einen carbocyclischen aromatischen Rest mit 6 bis 14, bevorzugt 6 bis 10 Gerüstkohlenstoffatomen.

Beispiele für gegebenenfalls substituierte **C₆-C₁₀-Aryl** sind Phenyl, 2,6-Diisopropylphenyl, o-, p-, m-Tolyl oder Naphthyl.

Weiterhin kann der carbocyclische aromatische Rest oder heteroaromatische Rest mit bis zu fünf gleichen oder verschiedenen Substituenten pro Cyclus substituiert sein, die ausgewählt sind ausder Gruppe Fluor, Cyano, C₁-C₁₂-Alkyl, C₁-C₁₂-Fluoralkyl, C₁-C₁₂-Fluoralkoxy, C₁-C₁₂-Alkoxy oder Di(C₁-C₈-allcyl)amino.

Die erfindungsgemäßen Verbindungen können auf einfache Weise hergestellt werden, indem DAD-Ligandenvorläufer der allgemeinen Formel (B) 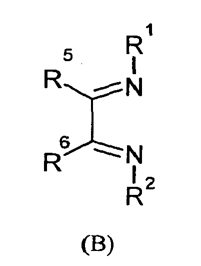 worin R¹, R², R⁵ und R⁶ die vorangehend genannte Bedeutung haben, in Gegenwart wenigstens eines Reduktionsmittels mit Ta- oder Nb-Komplexen der allgemeinen Formel (C),

[M(NR³)(R⁴)Cl₂L₂]

worin
M für Ta oder Nb steht
L für einen Liganded ausgewählt aus aliphatischen oder aromatischen Aminen, Ethern, Halogenid, bevorzugt Chlorid, oder Nitrilen, bevorzugt Acetonitril,
R³ oder R⁴ die vorangehend genannte Bedeutung haben,
in einem geeigneten Lösungsmittel, bevorzugt bei einer Temperatur von -20°C bis 120°C, umgesetzt werden.

Als geeignete Reduktionsmittel kommen unedle Metalle wie z.B. Mg, Zn, Li, Na, Al etc. in Frage. Geeignete Lösungsmittel sind beispielsweise Ether, wie z.B. THF, Diethylether oder 1,2-Dimethoxyethan, dipolar-aprotische Lösungsmittel, wie z.B. Acetonitril, N,N-Dimethylformamid oder tert.-Amine oder aliphatische oder aromatische Kohlenwasserstoffe, wie z.B. Toluol, Pentan, Hexan, etc., sowie Mischungen aus diesen oder Mischungen mit gegebenenfalls weiteren Lösungsmitteln. Die Ta- oder Nb-Komplexe der allgemeinen Formel (C) [M(NR³)(R⁴)Cl₂L₂] sind nach allgemein bekannten Verfahren in isolierter Form oder in-situ herstellbar.

Darüber hinaus ist es auch möglich, den DAD-Ligandenvorläufer der allgemeinen Formel (B) vorab in einem geeigneten Lösungsmittel mit dem Reduktionsmittel zu reduzieren, so dass Lösungen der vorreduzierten DAD-Liganden, wie z.B. bei Verwendung von Li als Reduktionsmittel Li[DAD] oder Li₂[DAD], mit der Lösung der Komplexe der allgemeinen Formel (C) umgesetzt werden. Bei sorgfältiger Wahl und Kontrolle der Reaktionstemperatur zwischen -20°C und 120°C ist es auch möglich, die erfindungsgemäßen Verbindungen in einer Eintopfsynthese herzustellen, bei der z.B. TaCl₅ mit dem oder den Amin(en) H₂NR³ oder H₂NR⁴, dem Reduktionsmittel und dem DAD-Ligandenvorläufer der allgemeinen Formel (B) zusammengegeben und zur Reaktion gebracht wird.

Zur Isolation der erfindungsgemäßen Verbindungen wird das Lösungsmittel beispielsweise mittels Abdestillieren unter vermindertem Druck entfernt, und es kann sich eine weitere Reinigung mittels Waschen sowie eine nachfolgende Trocknung anschließen. Solche geeigneten Verfahren sind dem Fachmann bekannt.

Weiterer Gegenstand der Erfindung ist die Verwendung von Verbindungen gemäß Formel I als Precursor für Tantalnitrid-(TaN)-schichten mittels Chemical Vapour Deposition sowie die entsprechend aus den Verbindungen der Formel I durch CVD hergestellten TaN-Schichten. Bevorzugt sind Verbindungen der Formel II, besonders bevorzugt sind Verbindungen der Formel III, ganz besonders bevorzugt sind Verbindungen der Formel IV bis XIII in diesen Verfahren einzusetzen.
Die Definition der Reste entspricht hierbei den oben angegebenen Definitionen.

Gegenstand der Erfindung sind ferner Substrate, die eine TaN- oder eine NbN-Schicht aufweisen, die aus den Verbindungen der Formel I oder bevorzugt der Formel II mit den oben angegebenen Definitionen für die verschiedenen Reste hergestellt ist.

Als technische Vorteile der in der vorliegenden Erfindung vorgeschlagenen Verbindungen sind die folgenden Punkte anzusehen:
1) Die Synthese der flüchtigen Ta- und Nb-Verbindungen verzichtet auf teure Lithiumalkyle oder ―amide.
2) Die Einführung des DAD-Liganden als CVD-geeignete Abgangsgruppe für Ta-III- oder Nb-III-Schichten reduziert die Gefahr eines unerwünschten C-Einbaus in die Substratbeschichtung.
3) Durch die Einführung weiterer stabiler Abgangsgruppen, wie zum Beispiel Cyclopentadienyl (Cp) oder Boranat (BH₄), wird die Reduktion des C-Einbau in der CVD weiter gefördert.
4) In der Kombination mit N-Edukten, beispielsweise Hydrazin-Derivaten (wie z.B. 1,1-Dimethylhydrazin, bzw. tert.-Butylhydrazin) ist bei der CVD eine gezielte Veränderung der Schicht-Zusammensetzung möglich.
5) Gezielte Beeinflussung des Oxidationszustandes Ta-III- bzw. Ta-V-Verbindungen und ihrer Nb-Analoga.

Die Erfindung betrifft auch die Verwendung der erfindungsgemäßen Ta- und Nb-Verbindungen zur Abscheidung Ta- bzw. Nb-haltiger Schichten, gegebenenfalls unter Beimischung weiterer Verbindungen, zur definierten Einstellung bestimmter Konzentrationen der jeweiligen Elemente in der Schicht mittels Chemical Vapour Deposition (CVD) mit folgenden Verfahrensschritten: Ein geeignetes Substrat, wie z.B. eine Si-Scheibe oder auch eine bereits weitere oberflächenstrukturierte Einzel- oder Mehrfachschichten aufweisende Si-Scheibe, wie sie typischerweise für die Herstellung von Si-basierenden integrierten Schaltkreisen eingesetzt werden, wird in eine CVD-Anlage eingebracht und auf eine für die Schichtabscheidung geeignete Temperatur im Bereich von 250°C bis 700°C aufgeheizt. Ein Trägergas wird mit den Edukten in definierten Konzentrationen beladen, wobei inerte Gase wie z.B. N₂ und/oder Ar, auch in Kombination mit inerten, verdampften Lösungsmitteln wie z.B. Hexan, Heptan, Octan, Toluol oder Butylacetat, als Trägergas eingesetzt werden können, und auch reaktive, z.B. reduzierende Gase, wie z.B. H₂, zugesetzt werden können. Das beladene Trägergas wird für eine definierte Expositionsdauer über die Oberfläche des aufgeheizten Substrates geleitet, wobei die jeweiligen Konzentrationen an Edukten und die Expositionsdauer mit der Maßgabe aufeinander abgestimmt sind, dass eine Ta- bzw. Nb-haltige Schicht mit einer vorgegebenen Schichtdicke und einer vorgegebenen Zusammensetzung auf der Oberfläche des Substrats entweder amorph, nano- oder mikrokristallin bzw. polykristallin gebildet wird. Typische Expositionsdauern sind je nach Abscheiderate beispielsweise wenige Sekunden bis hin zu mehreren Minuten oder Stunden. Typische Abscheideraten können beispielsweise von 0,1 nm/sec bis 1 nm/sec sein. Es sind jedoch auch andere Abscheideraten möglich. Typische Schichtdicken sind beispielsweise 0,1 bis 100 nm, bevorzugt 0,5 bis 50 nm, besonders bevorzugt 1 bis 10 nm.

Vorteilhafterweise werden im Rahmen der CVD-Technologie neben den Edukten gemäß Formel I, bevorzugt der Formeln II bis XIII zur Herstellung von reinen Ta- bzw. Nb-Metallschichten (Ta- bzw. Nb-reichen Einzelschichten), Ta- bzw. Nb-reichen Schichten als auch Ta-N- bzw. Nb-N-haltigen Mischschichten auch die folgenden Edukte zur gezielten Einstellung der N-Konzentration von Ta-N- bzw. Nb-N-haltigen Mischsystemschichten - auch nachfolgend N-Edukte genannt - eingesetzt: Ammoniak (NH₃), oder C₁-C₈-Monoalkylhydrazine, insbesondere *tert*.Butylhydrazin (^{t}Bu-NH-NH₂), und/oder C₁-C₅-1,1-Dialkylhydrazine, insbesondere 1,1-DimethyIhydazin ((CH₃)₂N-NH₂), wobei die Alkylgruppen linear oder verzweigt sein können. Insbesondere zur Beeinflussung der Stabilität der hergestellten Mischsystemschichten in nachfolgenden Hochtemperaturausheizschritten kann es günstig sein, weitere Elemente in der CVD-Abscheidung beizumischen, um das Rekristallisationsverhalten der gebildeten Schicht zu beeinflussen. Für die Anwendung in Si-basierenden integrierten Schaltkreisen kommt hierfür besonders das Element Si in Frage. Vorteilhafterweise werden für die Herstellung von Ta(oder Nb)-N-Si-haltigen Mischsystemschichten neben den oben angesprochenen Edukten die folgenden Edukte für Si - auch nachfolgend Si-Edukte genannt - in der CVD-Technologie eingesetzt: Silan (SiH₄), und/oder Disilan (Si₂H₆), und/oder C₁-C₈-Monoalkylsilane, insbesondere *tert*.Butylsilan (tBu-SiH₃), und/oder C₁-C₈-Dialkylsilane, insbesondere Di-*tert*.butylsilan (tBu₂SiH₂), und/oder C₁-C₈-Trialkylsilane, insbesondere Triethylsilan ((C₂H₅)₃SiH), und/oder C₁-C₈-Tetraalkylsilane, insbesondere Tetraethylsilan ((C₂H₅)₄Si), wobei die Alkylgruppen linear oder verzweigt sein können.

Grundsätzlich richten sich die genauen Konzentrationen der Edukte nach den thermischen Zerlegungseigenschaften der jeweiligen Edukte im CVD-Prozess. Vorzugsweise werden die Edukte in folgenden Mol-Verhältnissen eingesetzt: N-Edukt/Ta- bzw. Nb-Edukt 0 bis 20 000, Si-Edukte/Ta- bzw. Nb-Edukt 0-100. Die Oberflächentemperatur des Substrats wird bevorzugt im Bereich von 300°C bis 600°C eingestellt. Der Gesamtdruck von Trägergas und Edukten wird bevorzugt auf Drücke im Bereich von 10 hPa bis 1000 hPa eingestellt, wobei das Verhältnis des Partialdrucks der Summe aller Edukte zum Partialdruck des Trägergases zwischen 0,0001 bis 0,5 liegt. Die Abscheiderate beträgt vorzugsweise 0,05 nm/min bis 50 nm/min.

Die erfmdungsgemäßen Tantal- und Niobverbindungen eignen sich auch als Prekursoren für Tantaloxid(Ta₂O₅)-Schichten bzw. Nioboxid(Nb₂O₅)-Schichten, die durch ihre hohen Dielektrizitätskonstanten für die Mikroelektronik interessant sind.

Die folgenden Beispiele dienen der beispielhaften Erläuterung der Erfindung und sind nicht als Beschränkung aufzufassen.

### Beispiele

In den nachfolgenden Beispielen bedeuten die Abkürzungen und abgekürzten Verbindungsnamen folgende Strukturen:
- D^{t}BuAD =: 1,4-Di-tert-butyl-1,4-diaza-butadien
bzw. sein zweiwertiger Rest = 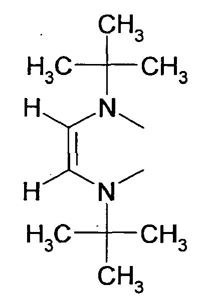
- ^{t}Bu =: tert. Butyl
- ^{t}BuN =: tert.Butylimino = ^{t}Bu-N=
- Me =: Methyl
- Py =: Pyridin
- Bz =: Benzyl
- AcAc =: einwertiger Rest der Enolat-Form des Acetylacetons = 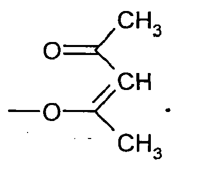
- Cp =: Cyclopentadienyl
- Ind =: einwertiger Rest des Indens = 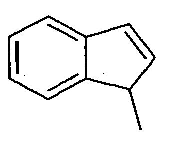
- Dip =: 2,6-Di-isopropyl-phenyl = 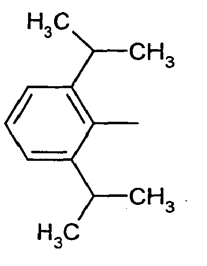
- all =: Allyl

### Beispiele zur Herstellung nicht erfindungsgemäßer Vorprodukte

### Vorprodukt Beispiel A: Herstellung von Li₂D^{t}BuAD

870 mg (125 mmol) Lithium wurden zu einer Lösung von 10 g (60 mmol) D^{t}BuAD in 200 ml Diethylether unter Eiskühlung zugegeben. Nach 8 h Rühren bei 23°C wurde die orangefarbene Lösung filtriert. Anschließend wurde das Lösungsmittel bei 20 mbar abdestilliert und der Rückstand im Hochvakuum 48 h getrocknet. Ausbeute 10,8 g (praktisch quantitativ).

Analytik:
¹H-NMR (δ gegen TMS, C₆D₅CD₃, 300 K, 200 MHz): 5,52 (s, 2H), 1,10 (s, 18H).

### Vorprodukt Beispiel B: Herstellung von [Ta(^{t}BuN)(^{t}BuNH)Cl₂2Py]

61,3 ml ^{t}BuNH₂ (587 mmol) in 50 ml CH₂Cl₂ wurden unter Eiskühlung zu einer Suspension von 21,0 g TaCl₅ (58,7 mmol) in 200 ml CH₂Cl₂ getropft. Danach wurde das Reaktionsgemisch auf 23°C erwärmt und 4 h gerührt. Die erhaltene Suspension wurde erneut mit einem Eisbad gekühlt und eine Lösung von 23,7 ml (294 mmol) Pyridin in 50 ml CH₂Cl₂ hinzugegeben. Nach 4 h Rühren bei 23°C wurden 150 m Hexan zum Reaktionsgemisch hinzugefügt und die erhaltene Lösung durch Celite filtriert. Der Rückstand wurde noch zweimal mit je 100 ml CH₂Cl₂/Hexan 1:1 bis zur Farblosigkeit gewaschen. Die vereinigten Lösungen wurden bei 20 mbar von allen flüchtigen Bestandteilen befreit, der Rückstand mit Hexan gewaschen und getrocknet. Hellgelbes, mikrokristallines Produkt, Ausbeute 25,9 g (84 % d. Th.) Schmp. > 120°C (Zers.).

| Elementaranalyse: | | | |
|---|---|---|---|
| Ber. (%) für C₁₈H₂₉N₄Cl₂Ta (M = 553,31 g·mol⁻¹): | C 39,07; | H 5,28; | N 10,13 |
| Gef. (%): | C 40,15; | H 5,17; | N 10,02 |

MS-EI: 379 (M⁺― 2 Py ― Me, 20 %), 323 (M⁺ ― 2 Py ― (CH₃)₂CCH₂ ― Me, 42 %), 41 (100 %).
¹H-NMR (300,1 MHz, CDCl₃): δ = 1,28 (s, 9H, NHC(CH₃)₃), 1,31 (s, 9H, NC(CH₃)₃), 7,44 (*pseudo*-t, 4H, m-H_{py}), 7,86 (tt, J₁ = 7,7 Hz, J₂ = 1,5 Hz, 2H, p-H_{py}), 8,60 (breites s, 1H, NHC(CH₃)₃), 9,40 (dd, J₁ = 6,9 Hz, J₂ = 1,5 Hz, 4H, o-H_{py})
¹³C{¹H}-NMR (CDCl₃, 75 MHz, 300 K): 32,3 (NC(CH₃)₃), 33,9 (NHC(CH₃)₃), 56,4 (NHC(CH₃)₃), 64,8 (s, NC(CH₃)₃),124,1 (m-Py), 139,2 (p-Py), 153,5 (o-Py).

### Vorprodukt Beispiel C: Herstellung von [(D^{t}BuAD)(^{t}BuN)Ta(µ-Cl)]₂

43,8 ml tert.Butylamin (418,7 mmol) wurden bei 0 °C unter Rühren zu einer Suspension von 50,00 g TaCl₅ (139,6 mmol) in 300 ml CH₂Cl₂ zugetropft. Das Reaktionsgemisch wurde auf 23°C erwärmt und 3 h bei dieser Temperatur gerührt. Danach wurden 23,49 g (139,6 mmol) DtBuAD zugegeben und die resultierende Suspension 8 h gerührt. Danach wurde nach Zugabe von 150 ml Hexan filtriert. Aus dem Filtrat wurden die flüchtigen Bestandteile bei 20 mbar entfernt und der Rückstand anschließend in 200 ml THF gelöst. Hierzu wurden 1,94 g (279,2 mmol) Lithium-Pulver langsam und unter Eiskühlung hinzugegeben (sofortige dunkelbraune Färbung). Nach 8 h Rühren wurde das Lösungsmittel bei 20 mbar abgedampft und der Rückstand zweimal mit je 150 ml Diethylether extrahiert. Aus dem Extrakt wurde das Lösungsmittel bei 20 mbar abgedampft. Der Rückstand wurde bei 160 °C/10⁻⁴ mbar sublimiert. Ausbeute: 38,8 g (61 % d. Th.), Schmp. 150,0°C.

| Elementaranalyse: | | | |
|---|---|---|---|
| Ber. (%) für monomeres C₁₄H₂₉N₃ClTa (M= 455,81 g mol⁻¹): | C 36,89; | H 6,41; | N 9,22 |
| Gef.(%): | C 36,39; | H 6,37; | N 9,18 |

MS-EI: 455 (M⁺, 9 %), 440 (M⁺ - Me, 21 %), 399 (M⁺ - Me₂C=CH₂, 7 %), 384 (M⁺ - Me - Me₂C=CH₂, 5%), 328 (M⁺ - Me - 2·Me₂C=CH₂, 5%), 58 (100 %)
¹H-NMR (C₆D₆, 300 MHz, 300 K): 6,07 (bs, 2H, *CH*-D^{t}BuAD), 1,47 (s, 9H, N*^{t}Bu*), 1,35 (s, 18H, *^{t}Bu*-D^{t}BuAD)
¹³C{¹H}-NMR (C₆D₆, 75 MHz, 300 K): 103,8 (*C*H-D^{t}BuAD), 65,7 (N*C*Me₃), 56,9 (*C*Me₃-D^{t}BuAD), 33,8 (NC*Me₃*), 31,1 (C*Me₃*-D^{t}BuAD)
IR (KBr, cm⁻¹): 3036(w), 1503(w), 1456(s), 1364(s), 1356(w), 1285(s), 1217(s), 1146(m), 1113(w), 1069(w), 1038(w), 1026(w), 1018(w), 964(w), 870(m), 810(m), 770(s), 723(w), 567(w), 544(w), 511(w), 453(w).

### Vorprodukt Beispiel D: Herstellung von [(D^{t}BuAD)(^{t}BuN)Nb(µ-Cl)]₂

500 mg des Pyridinkomplexes aus Beispiel 19 wurden bei 150°C/ /10⁻⁴ mbar sublimiert. Ausbeute: 230 mg (56%). Schmp. 188°C. Analytik analog Vorprodukt Beispiel E.

### Vorprodukt Beispiel E: Herstellung von [(D^{t}BuAD)(^{t}BuN)Nb(µ-Cl)]₂

23,2 ml tert.Butylamin (222 mmol) wurden bei 0°C unter Rühren zu einer Suspension von 20,00 g NbCl₅ (74 mmol) in 300 ml CH₂Cl₂ zugetropft. Das Reaktionsgemisch wurde auf 23°C erwärmt und 3 h bei dieser Temperatur gerührt. Danach wurden 12,5 g (74 mmol) D^{t}BuAD zugegeben und die resultierende Suspension 8 h gerührt. Danach wurde nach Zugabe von 150 ml Hexan filtriert. Aus dem Filtrat wurden die flüchtigen Bestandteile bei 20 mbar entfernt und der Rückstand anschließend in 200 ml THF gelöst. Hierzu wurden 1,0 g (148 mmol) Lithium-Pulver langsam und unter Eiskühlung hinzugegeben. Nach 8 h Rühren wurde das Lösungsmittel bei 20 mbar abgedampft und der Rückstand zweimal mit je 150 ml Diethylether extrahiert. Aus dem Extrakt wurde das Lösungsmittel bei 20 mbar abgedampft. Der Rückstand wurde bei 160°C/10⁻⁴ mbar sublimiert. Ausbeute: 12,9 g (47 % d. Th.), Schmp. 188,4°C.

| Elementaranalyse: | | | |
|---|---|---|---|
| Ber. (%) für monomeres C₁₄H₂₉N₃ClNb (*M*= 367,77 g mol⁻¹): | C 45,72; | H 7,95; | N 11,43 |
| Gef. (%): | C 45,88; | H 8,04; | N 11,41 |

MS-EI: 367 (M⁺, 1 %), 352 (M⁺ ― Me, 1 %), 296 (M⁺ ― Me₂C=CH₂ - Me, 1 %), 5 8 (100%).
¹H-NMR (C₆D₆, 300 MHz, 300 K): 6,08 (breites s, 2H, *CH-*D^{t}BuAD), 1,45 (s, 9H, N*^{t}Bu*), 1,38 (s, 18H, *^{t}Bu*-D^{t}BuAD).
¹³C{¹H}-NMR (C₆D₆, 75 MHz, 300 K): 106,0 (*C*H-D^{t}BuAD), 57,7 (*C*Me₃-D^{t}BuAD), 32,4 (NC*Me₃*), 30,8 (C*Me₃*-DAD).
IR (KBr, cm⁻¹): 3032(w), 1491(w), 1456(s), 1393(w), 1360(m), 1263(s), 1246(w), 1215(s), 1155(w), 1144(w), 1092(w), 1061(w), 1036(w), 1026(w), 1017(w), 951(w), 870(m), 810(m), 774(s), 723(w), 698(w),669(w), 584(w), 569(m), 540(w), 515(w).

### Erfindungsgemäße Beispiele

### Beispiel 1: Herstellung von (D^{t}BuAD)(^{t}BuN)TaCl als Pyridin-Komplex

Zu einer Lösung von 5,00 g (9,7 mmol) ^{t}BuN=TaCl₃2Py (hergestellt nach Lit. J. Sundermeyer, J. Putterlik, M. Foth, J. S. Field, N. Ramesar, Chem. Ber. 1994, 127, 1201-1212) in 20 ml THF wurde eine Lösung von 1,76 g (9,7 mmol) Li₂D^{t}BuAD aus Vorprodukt-Beispiel A in 20 ml THF bei -80°C zugetropft. Nach 30 min Rühren wurde das dunkelbraune Reaktionsgemisch erwärmt und für weitere 10 h bei 23°C gerührt. Nach Abdestillation aller flüchtigen Bestandteile wurde der Rückstand zweimal mit je 10 ml Diethylether extrahiert. Die Etherphasen wurden vereinigt, der Ether abdestilliert und der gelbe Rückstand zweimal mit je 10 ml Hexan gewaschen. Ausbeute 2,11 g; darüber hinaus wurden durch Kristallisation der Mutterlauge bei -80°C weitere 0,64 g erhalten. Gesamtausbeute 2,75 g (53,1 % d. Th.), Schmp. 142,8°C.

| Elementaranalyse: | | | |
|---|---|---|---|
| Ber. (%) für C₁₉H₃₄N₄ClTa (*M*= 534,91 g·mol⁻¹): | C 42,66; | H 6,41; | N 10,47 |
| Gef. (%): | C 42,27; | H 5,97; | N 10,19 |

MS-EI: 455 (M⁺ ― Py, 15 %), 440 (M⁺ ― Py ― Me, 39 %), 399 (M⁺ ― Py ― Me₂C=CH₂, 13 %),384 (M⁺ ― Py ― Me ― Me₂C=CH₂, 2 %), 343 (M⁺ ― Py ― 2·Me₂C=CH₂, 1 %), 328 (M⁺ ― Py ― Me-2·Me₂C=CH₂, 7 %), 287 (M⁺ ― Py ― 3·Me₂C=CH₂, 11%), 79 (Py ⁺, 100 %)
¹H-NMR (δ gegen TMS, C₆D₆, 300 MHz, 300 K): 8,57 (d, ³J_{HH} = 4,9 Hz, 2H, o-*Py*), 6,77 (t, ³J_{HH}= 7,7 Hz, 1H, p*-Py),* 6,45 (pseudo-t, ³J_{HH} = 6,7 Hz, 2H, m-Py), 6,17 (breites s, 2H, C*H*-D^{t}BuAD), 1,55 (s, 9H,*^{t}Bu*N), 1,34 (breites s, 18H, *^{t}Bu*-D^{t}BUAD)
¹³C {¹H}-NMR (C₆D₆, 75 MHz, 300 K): 150,7, 137,5 und 124,0 (Py), 65,5 (*C*Me₃N), 56,6 (*C*Me₃-DtBuAD), 34,2 (NC*Me₃*), 30,9 (C*Me₃*-D^{t}BuAD)
¹³C {¹H}-NMR (d₈-Toluol, 400 MHz, 230 K): 152,9, 139,9 und 126,8 (Py), 111,8 und 101,4 (*C*H-D^{t}BuAD), 68,1 (N*C*Me₃), 59,0 and 58,8 (*C*Me₃-D^{t}BuAD), 36,7 (NC*Me₃*), 33,5 and 33,0 (C*Me₃*-D^{t}BuAD)
IR (KBr, cm⁻¹): 3075(w), 3040(w), 1604(w), 1504(w), 1458(s), 1444(m), 1359(m), 1354(m), 1275(s), 1251(w), 1217(s), 1145(m), 1145(w), 1064(w), 1045(w), 1012(w), 871(w), 814(w), 771(m), 761(m), 723(w), 698(m), 636(w), 567(w), 538(w), 507(w).

### Beispiel 2: Herstellung von (D^{t}BuAD)(^{t}BuN)Ta(NH^{t}Bu) aus [(^{t}BuN)(^{t}BuNH)TaCl₂(^{t}BuNH₂)]₂

Zur gelben Lösung von 3,50 g (3,7 mmol) [(^{t}BuN)(^{t}BuNH)TaCl₂(^{t}BuNH₂)]₂ (hergestellt nach Lit. K. C. Javaratne, G. P. A. Yap, B. S. Haggerty, A. L. Rheingold, C. H. Winter, Inorg. Chem. 1996, 35, 4910 - 4920) in 40 ml THF wurden 1,26 g D^{t}BuAD (7,5 mmol) zugegeben. Die Mischung wurde anschließend ca. 30 min bei 23°C gerührt. Danach wurden 0,19 g (7,8 mmol) MagnesiumPulver hinzugefügt und weitere 10 h bei 23°C gerührt. Nach vollständiger Auflösung des Mg wurde das THF bei 20 mbar abgezogen und das verbleibende gelbe Öl zweimal mit 25 ml Hexan extrahiert. Nach Abdampfen des Hexans ergab die Sublimation bei 80°C/10⁻² mbar das Produkt als schwach gelben Festkörper. Ausbeute: 1,54 g (60 % d. Th.), Schmp. 70°C.
Analytik:
¹H-NMR (C₆D₆, 300 MHz, 300 K): 5,62 (s, 2H, C*H*-D^{t}BuAD), 3,41 (s, 1H, N*H*), 1,56 (s, 9H, N*^{t}Bu*), 1,32 (s, 18H, *^{t}Bu*-D^{t}BuAD), 1,27 (s, 9H, NH*^{t}Bu*)
¹³C {¹H}-NMR (C₆D₆, 75 MHz, 300 K): 102,6 (C*H*-D^{t}BuAD), 64,9 (N*C*Me₃), 55,7 (*C*Me₃-D^{t}BuAD), 53,5 (NH*C*Me₃), 35,3 (NC*Me₃*), 35,2 (NHC*Me₃*), 32,0 (C*Me₃*-D^{t}BuAD)
IR (KBr, cm⁻¹): 3246(w), 3030(w), 1504(w), 1456(s), 1388(w), 1361(s), 1352(m), 1280(s), 1221(s), 1140(m), 1107(w), 1072(w), 1037(w), 1024(w), 985(m), 960(w), 920(w), 870(m), 816(w), 781(w), 771(m), 756(w), 590(w), 567(m), 527(m), 445(w).

### Beispiel 3: Herstellung von (D^{t}BuAD)(^{t}BuN)Ta(NH^{t}Bu) aus (^{t}BuN)(^{t}BuNH)TaCl₂2Py

Anstelle von [(^{t}BuN)(^{t}BuNH)TaCl₂(^{t}BuNH₂)]₂ wurde (^{t}BuN)(^{t}BuNH)TaCl₂·2Py (2,05 g = 3,7 mmol, Vorprodukt Beispiel B) als Ausgangsmaterial bei sonst gleicher Vorgehensweise benutzt. Ausbeute 1,22 g = 67 % d. Th., Schmp. 70°C.

| Elementaranalyse: | | | |
|---|---|---|---|
| Ber. (%) für C₁₈H₃₉N₄Ta (M= 492,49 g mol ⁻¹): | C 43,90; | H 7,98; | N 11,38 |
| Gef. (%): | C 42,56; | H 7,89; | N 10,88 |

MS-EI: 492 (M⁺, 33 %), 477 (M⁺ ― Me, 100 %), 436 (M⁺ ― Me₂C=CH₂, 10 %), 421 (M⁺ ― Me ― Me₂C=CH₂, 10 %), 380 (M⁺ ― 2·Me₂C=CH₂, 1 %), 365 (M⁺ - Me - 2·Me₂C=CH₂, 2 %), 309 (M⁺-Me―3·Me₂C=CH₂, 1%)

Weitere spektroskopische Daten (¹H-NMR, ¹³C {¹H}-NMR und IR) wie in Beispiel 2.

### Beispiel 4: Herstellung von (D^{t}BuAD)(^{t}BuN)Ta(NH^{t}Bu) (Direktsynthese aus TaCl₅)

Zu einer Suspension von 50,0 g TaCl₅ (139,58 mmol) in 500 ml Toluol wurden 145,84 ml tert.Butylamin (1,40 mol) unter Eiskühlung zugetropft. Nach 8 h Rühren bei 23°C wurde die gelbe Lösung filtriert und das Lösungsmittel bei 20 mbar abgezogen. Das ölige Zwischenprodukt wurde ohne weitere Reinigung in 250 ml THF gelöst, hierzu wurden 23,49 g (139,6 mmol) D^{t}BuAD, gefolgt von 3,39 g Mg- Pulver (139,6 mmol) zugegeben. Das Reaktionsgemisch wurde 12 h bei 23°C gerührt, danach wurde das Lösungsmittel bei 20 mbar abgezogen. Die zweimalige Extraktion des Rückstandes mit je 150 ml Hexan ergab ein gelbes, öliges Rohprodukt, das durch Sublimation bei 80°C/10⁻² mbar gereinigt wurde. Ausbeute 35,7 g (52 % d. Th.), Schmp. 70°C.

Spektroskopische Daten (¹H-NMR, ¹³C {¹H}-NMR und IR) wie in Beispiel 2.

### Beispiel 5: Herstellung von (D^{t}BuAD)(^{t}BuN)Ta(O^{t}Bu) aus (DtBuAD)(^{t}BuN)Ta(NH^{t}Bu)

Zu einer Lösung von 5,00 g (10,15 mmol) (D^{t}BuAD)(^{t}BuN)Ta(NH^{t}Bu) aus Beispiel 2 in 100 ml Hexan wurde bei -80°C eine Lösung von 0,75 g tert.Butanol (10,15 mmol) in 100 ml Hexan zugetropft. Das Reaktionsgemisch wurde anschließend 3 h bei 23°C gerührt. Das Lösungsmittel wurde bei 20 mbar abgezogen und das farblose Produkt bei 100°C/10⁻² mbar sublimiert. Ausbeute: 4,65 g (93 % d. Th.), Schmp. 79°C.

| Elementaranalyse: | | | |
|---|---|---|---|
| Ber. (%) für C₁₈H₃₉N₃OTa (*M*= 493,47 g mol⁻¹): | C 43,81; | H 7,76; | N 8,52 |
| Gef. (%): | C 42,89; | H 7,88; | N 8.29 |

MS-EI: 493 (M⁺ , 44 %), 478 (M⁺ - Me, 21 %), 437 (M⁺ - Me₂C=CH₂, 5 %), 422 (M⁺ - Me - Me₂C=CH₂, 100 %), 381 (M⁺ - 2·Me₂C=CH₂, 60 %), 366 (M⁺ - Me - 2·Me₂C=CH₂, 5 %), 310 (M⁺ - Me 3·Me₂C=CH₂, 2 %)
¹H-NMR (δ gegen TMS, C₆D₆, 300 MHz, 300 K): 5,82 (s, 2H, C*H*-D^{t}BUAD), 1,54 (s, 9H, N*^{t}Bu*), 1,33 (s, 9H, O*^{t}Bu*), 1,32 (s, 18H,*^{t}Bu*-D^{t}BuAD)
¹³C{¹H}-NMR (C₆D₆, 75 MHz, 300 K): 104.4 (C*H*-DAD), 55,9 (CMe₃-D^{t}BuAD), 35,3 (s, NC*Me₃*), 33,3 (OC*Me₃*), 32,0 (C*Me₃*-D^{t}BuAD)
IR: (υ, cm⁻¹) 3034(w), 1586(w), 1361(s), 1286(s), 1261(w), 1223(s), 1188(s), 1142(m), 1072(w), 1008(s), 959(w), 920(w), 869(m), 806(m), 789(m), 772(m), 722(w), 563(w), 529(w), 514(w), 471(w).

### Beispiel 6: Herstellung von (D^{t}BuAD)(^{t}BuN)Ta(O^{t}Bu) aus (D^{t}BuAD)(^{t}BuN)TaCl(Py)

Zu 200 mg (0,37 mmol) (D^{t}BuAD)(^{t}BuN)TaCl(Py) aus Beispiel 1 in 10 ml THF wurden 42 mg (0,37 mmol) ^{t}BuOK in 10 ml THF bei ― 80°C zugegeben. Nach 5 h Rühren bei 23°C wurde das Lösungsmittel bei 20 mbar abdestilliert. Der braune, ölige Rückstand wurde bei 100°C/10⁻² mbar sublimiert und ergab 95 mg Produkt (52 % d. Th. Ausbeute) vom Schmp. 79°C.

Spektroskopische Daten (¹H-NMR, ¹³C-NMR, IR) identisch zu Beispiel 5.

### Beispiel 7: Herstellung von (D^{t}BuAD)(^{t}BuN)Ta(AcAc) aus (D^{t}BuAD)(N^{t}Bu)Ta(NH^{t}Bu)

Zu einer Lösung von 1,00 g (2,0 mmol) (D^{t}BuAD)(^{t}BuN)Ta(NH^{t}Bu) aus Beispiel 4 in 10 ml Hexan wurden 0,20 g Acetylaceton (2,0 mmol), gelöst in 10 ml Hexan, bei - 80°C zugegeben. Anschließend wurde das Reaktionsgemisch 5 h bei 23°C gerührt. Nach Abdestillation des Lösungsmittels bei 20 mbar wurden 0,97 g (92 % d. Th.) des analytisch reinen Produkts als orangefarbenes Pulver isoliert, Schmp. 99,1°C.
MS-EI: 519 (M⁺, 74 %), 504 (M⁺ ― Me, 43 %), 448 (M⁺ ― Me₂C=CH₂, 3%), 57 (^{t}Bu⁺, 100 %)
¹H-NMR (δ gegen TMS, C₆D₆, 300 MHz, 300 K): 6,04 (s, 2H, C*H*-D^{t}BuAD), 5,06 (s, 1H, C*H*-AcAc), 1,60 (s, 6H, *Me*-AcAc), 1,56 (s, 18H, *^{t}Bu*-D^{t}BuAD), 1,47 (s, 9H, N*^{t}Bu*)
¹³C{¹H}-NMR (C₆D₆, 75 MHz, 300 K): 191,7 (*C*O-AcAc), 103,6 (C*H*-AcAc) 103,4 (C*H*-D^{t}BuAD), 55,7 (*C*Me₃-D^{t}BuAD), 54,2 (N*C*Me₃) 34,3 (NC*Me₃*), 31,5 (C*Me₃*-D^{t}BuAD), 26,1 (*Me*-AcAc)
IR (KBr, cm⁻¹): 1590(m), 1530(m), 1281(m), 1262(w), 1223(m), 1137(w), 1093(w), 1026(w), 968(w); 933(w), 861(w), 804(w), 762(w), 722(w), 665(w), 566(w), 534(w), 432(w). -

### Beispiel 8: Herstellung von (D^{t}BuAD)(^{t}BuN)Ta(AcAc) aus (D^{t}BuAD)Ta(N^{t}Bu)Cl(Py)

640 mg (1,2 mmol) (D^{t}BuAD)Ta(N^{t}Bu)Cl(Py) aus Beispiel 1 wurden in 15 ml THF gelöst. Hierzu wurde eine Suspension von 146 mg (1,2 mmol) Natrium-acetylacetonat in 10 ml THF bei -80°C zugegeben. Nach Erwärmen auf 23°C und 10 h Rühren bei dieser Temperatur wurde das Lösungsmittel bei 20 mbar abdestilliert. Der braune, ölige Rückstand wurde mit Hexan extrahiert und aus Hexan kristallisiert, wobei 0,28 g (50 % d. Th.) orangefarbene Kristalle vom Schmp. 99°C erhalten wurden.

Analytik: Spektroskopische Daten (MS, ¹H-NMR, ¹³C-NMR und IR) identisch zu Beispiel 8.

### Beispiel 9: Herstellung von (D^{t}BuAD)(^{t}BuN)TaBz als Pyridinkomplex

Zu 500 mg (0,94 mmol) [(D^{t}BuAD)(^{t}BuN)TaCl(Py)] aus Beispiel 1, gelöst in 10 ml Diethylether, wurde eine Suspension von 210 mg Benzylmagnesiumchlorid-THF-Komplex (0,94 mmol) in 10 ml Diethylether bei ― 80°C zugegeben. Nach 10 min wurde die orangefarbene Reaktionsmischung auf 23°C erwärmt und 5 h bei dieser Temperatur gerührt. Der gebildete gelbe Niederschlag wurde danach abfiltriert und mit 5 ml Diethylether gewaschen. Trocknung und anschließende Umkristallisation aus Hexan ergab 210 mg (38 % d. Th.) reines Produkte als orangefarbene Kristalle, Schmp. 117,7° C.
MS-EI: 511 (M⁺ ― Py, 3 %), 52 (100 %)
¹H-NMR (δ gegen TMS, C₆D₆, 300 MHz, 300 K): 8,21 (d, ³J_{HH} = 3,1 Hz, 2H, o-*Py*), 6,91 (t, ³J_{HH}= 7,6 Hz, 1H, m*-Bz),* 6,72-6,62 (m, 4H, o- und p-*Bz* mit p-*Py* überlappt), 6,30 (pseudo-t, ³J_{HH} = 6,7 Hz, 2H, *m-Py),* 6,06 (s, 2H, C*H*-D^{t}BuAD), 2,10 (breites s, 2H, C*H₂*-Bz), 1,58 (s, 9H, N*^{t}Bu*), 1,26 (breites s, 18H, *^{t}Bu*-DAD)
¹³C {¹H}-NMR (C₆D₆, 75 MHz, 300 K): 153,8 (*Cᵢ*-Bz), 150,2 (*o*-Py), 136,7 (*p*-Py), 127,2 (*m*-Bz), 126,5 (*o*-Bz), 123,8 (*m*-Py), 119,5 (*p*-Bz), 104,8 (C*H*-D^{t}BuAD), 65,5 (N*C*Me₃), 56,3 (*C*Me₃-D^{t}BuAD), 53,6 (*C*H₂-Bz), 34,8 (NC*Me₃*), 31,2 (C*Me₃*-D^{t}BuAD)
IR (KBr, cm⁻¹): 3057(w), 1602(w), 1591(w), 1361(w), 1276(m), 1262(w), 1218(m), 1172(w), 1152(w), 1137(w), 1094(w), 1071(w), 1058(w), 1040(w), 1028(w), 1014(m), 986(w), 960(w), 867(w), 805(m), 764(w), 747(w), 723(w), 693(w), 631(w), 592(w), 557(w), 538(w), 503(w).

### Beispiel 10: Herstellung von (D^{t}BuAD)(^{t}BuN)TaBz aus (D^{t}BuAD)(^{t}BuN)Ta(O^{t}Bu)

0,50 g (1,0 mmol) (D^{t}BuAD)(^{t}BuN)Ta(O^{t}Bu) aus Beispiel 6 und 0,22 g (1,0 mmol) Benzylmagnesiumchlorid-THF-Komplex (BzMgCl*THF) wurden bei 23°C gemischt. Dieses Feststoff-Gemisch wurde in 20 ml THF gelöst und die erhaltene Lösung 12 h bei 23°C gerührt. THF wurde anschließend im Vakuum (Rotationsverdampfer) entfernt und das zurückbleibende Öl mit 10 ml Hexan extrahiert. Hexan wurde abdestilliert und das Produkt destilliert (150 °C/10⁻⁴ mbar). Ausbeute: 0,14 g (27 %) als leicht gelbliche Flüssigkeit.
MS-EI: 511 (M⁺, 23 %), 496 (M⁺ - Me, 32 %), 420 (M⁺ - Bz, 5 %), 363 ([(D^{t}BuAD)TaN]⁺, 13%), 57 (^{t}Bu⁺, 100 %).
¹H-NMR(C₆D₆, 200 MHz, 300 K): 7,22 - 6,90 (m, 5H, *Bz*)*,* 5,66 (s, 2H, *CH*-D^{t}BUAD), 2,01 (s, 2H, C*H₂*-Bz), 1,62 (s, 9H, N*^{t}Bu*), 1,18 (s, 18H, *^{t}Bu*-D^{t}BuAD)
¹³C{¹H}-NMR (C₆D₆, 50 MHz, 300 K): 143,2, 128,4, 127,4 und 122,4 (*arom. Bz),* 103,1 (CH-D^{t}BuAD), 65,4 (N*C*Me₃), 57,6 (*C*H₂-Bz), 57,1 (*C*Me₃-D^{t}BuAD), 35,0 (NC*Me₃*), 31,3 (*CMe₃*-D^{t}BuAD).
IR (KBr, cm⁻¹): 3071(w), 3051(w), 3015(m), 2965(s), 2940(s), 2924(s), 2897(s), 2866(m), 1593(s), 1483(s), 1470(m), 1456(m), 1402(w), 1391(m), 1375(m), 1363(s), 1354(s), 1283(s), 1221(s), 1179(w), 1138(s), 1107(w), 1076(w), 1030(m), 1018(m), 993(w), 963(m), 872(s), 820(m), 808(w), 787(w), 777(s), 747(s), 694(s), 625(w), 565(m), 523(s), 451(m).

### Beispiel 11: Herstellung von (D^{t}BuAD)(^{t}BuN)TaBz aus [(DtBuAD)(^{t}BuN)Ta(µ-Cl)]₂

Anstelle von (D^{t}BuAD)(^{t}BuN)Ta(O^{t}Bu) wurden 0,46 g [(D^{t}BuAD)(^{t}BuN)Ta(µ-Cl)]₂ aus Vorprodukt Beispiel C (1,00 mmol, als monomere Verbindung gerechnet) als Ausgangsmaterial bei sonst gleicher Vorgehensweise wie in Beispiel 14 benutzt. Ausbeute 1,22 g = 74 % d. Th.

Analytische Daten (MS, ¹H-NMR, ¹³C-NMR, IR) identisch zu Beispiel 10.

### Beispiel 12: Herstellung von (D^{t}BuAD)(^{t}BuN)TaCp aus (D^{t}BuAD)(N^{t}Bu)TaCl(Py)

Zu 300 mg (0,56 mmol) (D^{t}BuAD)(N^{t}Bu)TaCl(Py) aus Beispiel 1 in 5 ml THF wurde bei -80°C eine Lösung von 40 mg Cyclopentadienyl-Lithium (0,56 mmol) in 5 ml THF getropft. Nach Ende der Zugabe wurde das Reaktionsgemisch auf 23°C erwärmt und weitere 3 h bei dieser Temperatur gerührt. Danach wurde das THF bei 20 mbar abdestilliert und der dunkle, ölige Rückstand zweimal mit 15 ml Hexan extrahiert. Umkristallisation mit Hexan und anschließende Sublimation bei 90°C und 10⁻² mbar ergab 130 mg (48 % d. Th.) analytisch reines Produkt vom Schmp. 65,3°C.

| Elementaranalyse: | | | |
|---|---|---|---|
| Ber. (%) für C₁₉H₃₄N₃Ta (*M*= 485,45 g mol⁻¹): | C 47,01; | H 7,06; | N 8,66 |
| Gef. (%): | C 45,03; | H 7,06; | N 7,93 |

MS-EI: 485 (M⁺ , 55 %), 470 (M⁺ ― Me, 100 %), 429 (M⁺ ― Me₂C=CH₂, 2 %), 414 (M⁺ ― Me― Me₂C=CH₂, 16 %),373 (M⁺ ― 2·Me₂C=CH₂, 2 %), 358 (M⁺ ―Me ― 2·Me₂C=CH₂, 8 %), 317 (M⁺ ― 3·Me₂C=CH₂, 10 %), 302 (M⁺ ― Me ― 3·Me₂C=CH₂, 3 %)
¹H-NMR (δ gegen TMS, C₆D₆, 300 MHz, 300 K): 5,67 (s, 2H, C*H*-D^{t}BuAD), 5,66 (s, 5H, C₅*H₅*), 1,30 (s, 9H, N*^{t}Bu*), 1,25 (s, 18H, *^{t}Bu*-D^{t}BuAD)
¹³C{¹H}-NMR (C₆D₆, 75 MHz, 300 K): 108,3 (CH-D^{t}BuAD), 100,8 (C₅H₅), 55,5 (CMe₃-D^{t}BuAD), 34,1 (NC*Me₃*), 31,9 (C*Me₃*-D^{t}BuAD)
IR (KBr, cm⁻¹): 3028(w), 1506(w), 1358(m), 1274(s), 1221(s), 1156(w), 1095(w), 1061(w), 1013(w), 958(w), 865(w), 795(s), 766(m), 722(w).

### Beispiel 13: Herstellung von (D^{t}BuAD)(^{t}BuN)TaCp aus CpTa(N^{t}Bu)Cl₂

Zu 2,00 g (5,15 mmol) CpTa(N^{t}Bu)Cl₂ (hergestellt nach Lit. S. Schmidt, J. Sundermeyer, J. Organomet. Chem. (1994), 472(1-2), 127-38) in 20 ml THF wurde bei - 80°C eine Lösung von 940 mg Li₂D^{t}BuAD (5,15 mmol) in 20 ml THF getropft. Nach Ende des Zutrppfens wurde durch Entfernung der Kühlung auf 23°C erwärmt und der Ansatz bei dieser Temperatur 8 h gerührt. Danach wurde das THF bei 20 mbar abgezogen und das Produkt mit 30 ml Hexan extrahiert. Sublimation bei 120°C/0,01 mbar ergab 500 mg (20,0 % d. Th.) (D^{t}BuAD)(^{t}BuN)TaCp als gelben Festkörper.

Spektroskopische Daten (¹H-, ¹³C-NMR- und IR-Spektren) identisch zu Beispiel 12.

### Beispiel 14: Herstellung von (D^{t}BuAD)(^{t}BuN)TaInd

Zu 500 mg (D^{t}BuAD)(^{t}BuN)TaCl(Py) (0,93 mmol) aus Beispiel 1 in 10 ml THF wurde bei -80°C eine Lösung von Indenyl-Lithium (114 mg, 0,93 mmol) in 10 ml THF gegeben und die Reaktionsmischung anschließend 8 h bei 23°C gerührt. THF wurde bei 20 mbar abdestilliert und der Komplex zweimal mit je 15 ml Hexan extrahiert. Abdestillation des Hexans bei 20 mbar ergab 300 mg (60 % d. Th.) des analytisch reinen Produkts. Schmp. 147,3°C.

| Elementaranalyse: | | | |
|---|---|---|---|
| Ber. (%) für C₂₃H₃₆N₃Ta (*M*= 535,51 g mol⁻¹): | C 51,59; | H 6,78; | N 7,85 |
| Gef. (%): | C 50,39; | H 6,79; | N 7,56 |

MS-EI: 535 (M⁺, 44 %), 520 (M⁺ ― Me, 87 %), 464 (M⁺―Me―Me₂C=CH₂, 7 %), 367 (M⁺― 3·Me₂C=CH₂, 4 %), 352 (M⁺―Me―3·Me₂C=CH₂, 3 %),57 (^{t}Bu⁺, 100 %)
¹H-NMR (δ gegen TMS, C₆D₆, 300 MHz, 300 K): 7,17 (d, 2H, J_{H-H} = 2.9 Hz, *Ind*), 6,92 (t, 1H, J_{H-H} = 3,2 Hz, *Ind*), 6,.92 (dd, 2H, J_{H-H} = 3,2 Hz, J_{H-H} = 2,9 Hz, *Ind*), 6,14 (d, 2H, J_{H-H} = 3,2 Hz, *Ind*), 5,11 (s, 2H, *CH-*D^{t}BuAD), 1,28 (s, 27H, N*^{t}Bu* überlappend mit *^{t}Bu*-D^{t}BuAD)
¹³C{¹H}-NMR (C₆D₆, 75MHz, 300K): 123,1, 122,8 und 110,6 (*Ind*), 107,4 (*C*H-D^{t}BuAD), 84,8 (*Ind*), 64,5 (N*C*Me₃), 55,8 (*C*Me₃-D^{t}BuAD), 34, (NC*Me₃*), 31,8 (C*Me₃*-D^{t}BuAD)
IR (KBr, cm⁻¹): 3075(w), 3038(w), 1504(w), 1464(s), 1360(m), 1329(w), 1279(s), 1248(w), 1221(s), 1157(w), 1095(w), 1064(w), 1038(w), 1026(w), 932(w), 868(m), 814(m), 783(s), 771(m), 740(w), 735(m), 600(w), 559(w).

### Beispiel 15: Herstellung von (D^{t}BuAD)(DipN)Ta(NHDip)

Eine Lösung von 0,72 g DipNH₂ (4,0 mmol) in 10 ml Hexan wurde bei 0°C zu einer Lösung von 1,00 g (2,0 mmol) (D^{t}BuAD)(^{t}BuN)Ta(NH^{t}Bu) aus Beispiel 2 in 10 ml Hexan hinzugetropft. Das Reaktionsgemisch wurde 24 h bei 23°C gerührt. Danach wurde die Lösung bis auf 5 ml eingedampft und stehen gelassen. Nach Abscheidung erster Kristalle wurde die Lösung auf -30°C abgekühlt, wobei das Produkt auskristallisierte. Abfiltrieren ergab 0,64 g (45 % d. Th) Produkt vom Schmp. 149,8°C.

| Elementaranalyse: | | | |
|---|---|---|---|
| Ber. (%) für C₃₄H₅₅N₄Ta (*M*= 700,79 g mol⁻¹): | C 58,27; | H 7,91; | N 7,99 |
| Gef. (%): | C 57,43, | H 7,93; | N 7,90 |

MS-EI: 700 (M⁺, 100 %), 524 (M⁺ - DipNH, 56 %)
¹H-NMR (δ gegen TMS, C₆D₆, 300 MHz, 300 K): 7,19 - 6,92 (m, 6H, *Dip),* 5,67 (s, 2H, *CH*-D^{t}BuAD), 4,69 (breites s, 1H, N*H*), 3,97 und 3,47 (sept, 2H, ³J_{HH} = 6,7Hz, C*H*-DipN und C*H*-DipNH) 1,27 (s, 18H, *^{t}Bu*-D^{t}BuAD), 1,24 und 1,22 (d, 12H, ³J_{HH} = 6,7Hz, C*H₃*-DipN überlappend mit C*H₃*-DipNH)
¹³C{¹H}-NMR (C₆D₆, 75 MHz, 300 K): 145,8, 142,8, 141,0, 123,7, 122,9, 122,5 and 122,0 (*arom. Dip*NH and *Dip*N), 102,9 (*C*H-D^{t}BuAD), 57,9 (*C*Me₃-D^{t}BuAD), 31,1 (C*Me₃*-D^{t}BuAD), 29,2 und 27,9 (*C*H-DipNH und *C*H-DipN), 24,4 und 23,6 (*C*H₃-DipNH und *C*H₃-DipN)
IR (KBr, cm⁻¹): 3270(m), 3048(w), 3032(w), 1620(w), 1588(w), 1431(m), 1364(s), 1323(w), 1296(w), 1251(w), 1221(s), 1159(w), 1142(m), 1115(w), 1099(w), 1074(w), 1057(w), 1045(w), 1024(w), 988(m), 963(w), 934(w), 889(w), 876(m), 864(w), 818(w), 802(w), 797(w), 777(w), 770(w), 750(m), 723(w), 698(w), 583(w), 567(w), 521(w), 446(w).

### Beispiel 16: Herstellung von (D^{t}BuAD)(^{t}BuN)Ta(BH₄)

2,00 g (4,39 mmol, als monomere Verbindung gerechnet) [(D^{t}BuAD)(^{t}BuN)Ta(µ-Cl)]₂ aus Vorprodukt Beispiel C und 0,17 g NaBH₄ (4,39 mmol) wurden in 50 ml THF suspendiert und bei 23°C 12 h gerührt. THF wurde bei 20 mbar abdestilliert und das Produkt mit 20 ml Hexan extrahiert. Aus dem Extrakt wurde das Lösungsmittel abgedampft und das zurückgebliebene rote Öl bei 60 °C/10⁻⁴ mbar sublimiert. Die Sublimation ergab 1,64 g (86 %d. Th.) blaßgelbes, festes Produkt vom Schmp. 69,5°C.

| Elementaranalyse: | | | |
|---|---|---|---|
| Ber. (%) für C₁₄H₃₃BN₃Ta (*M*= 435,20 g mol ⁻¹): | C 38,64; | H 7,64; | N 9,66 |
| Gef. (%): | C 38,86; | H 7,71; | N 9,47 |

MS-EI: 435 (M⁺, 11%), 420 (M⁺ - Me, 7 %), 406 (M⁺ - Me - BH₃, 13 %), 378 M⁺ - H - Me₂C=CH₂, 5 %), 365 (M⁺ - BH₃ - Me₂C=CH₂, 2 %), 58 (^{t}BuH⁺, 100 %)
¹H-NMR (δ gegen TMS in C₆D₆, 500 MHz, 300 K): 5,91 (s, 2H, *CH*-D^{t}BuAD), 1.73 (q, 4H,¹J_{BH} = 85 Hz, B*H₄*), 1,41 (s, 9H, N*^{t}Bu*), 1,24 (s, 18H, *^{t}Bu*-D^{t}BuAD)
¹³C{¹H}-NMR (C₆D₆, 125MHz, 300K): 105,8 (CH-DAD), 65,8 (NCMe₃), 57,0 (*C*Me₃-D^{t}BuAD), 34,5 (NC*Me₃*), 31,8 (C*Me₃*-D^{t}BuAD)
¹¹B-NMR (C₆D₅CD₃, 160 MHz, 300 K): -20,2 (pent,¹J_{BH} = 85Hz, *B*H₄)
IR (KBr, cm⁻¹): 3041(w), 2519(s), 2326(w), 2284(w), 2097(w), 2037(s), 1505(w), 1456(s), 1389(m), 1379(s), 1364(s), 1356(s), 1279(s), 1217(s), 1148(s), 1111(w), 1071(m), 1038(w), 1028(w), 961(m), 916(w), 874(s), 818(s), 810(w), 775(s), 723(w), 546(w).

### Beispiel 17: Herstellung von (D^{t}BuAD)(^{t}BuN)Ta(η³-all)

1,00 g [(D^{t}BuAD)(^{t}BuN)Ta(µ-Cl)]₂ (2,19 mmol, als monomere Verbindung gerechnet) aus Vorprodukt Beispiel C und 0,48 g Allylmagnesiumbromid-THF-Komplex (AllMgBr*THF) (2,19 mmol) wurden in 20 ml THF gelöst und bei 23°C 12 h gerührt. Danach wurde das Lösungsmittel bei 20 mbar abgezogen. Der verbleibende gelbe Festkörper wurde zweimal mit je 10 ml Hexan extrahiert. Nach Entfernung des Lösungsmittels im Vakuum (20 mbar) wurde bei 80°C/10⁻⁴ mbar sublimiert. Ausbeute: 0,74g (73 % d. Th.) (D^{t}BuAD)(^{t}BuN)Ta(η ³-all) als gelber Festkörper vom Schmp. 61,9°C.

| Elementaranalyse: | | | |
|---|---|---|---|
| Ber. (%) für C₁₇H₃₄N₃Ta (*M*= 461,43 g mol⁻¹): | C 44,25; | H 7,43; | N 9,11 |
| Gef. (%): | C 43,81; | H 7,37; | N 9,04 |

MS-EI: 461 (M⁺, 53 %), 446 (M⁺ - Me, 25 %), 420 (M⁺ - all, 22 %), 363 ([(D^{t}BuAD)TaN]⁺, 21 %), 57 (^{t}Bu⁺, 100 %).
¹H-NMR (δ gegen TMS in C₆D₆, 300 MHz, 300 K): 6,44 (pent, 1H, ³J_{HH} = 11,4Hz, *η³-all*), 5,50 (s, 2H, *CH*-DAD), 2,31 (breites s, 4H, *η³-all*), 1,36 (s, 18H, *^{t}Bu*-D^{t}BuAD), 1,26 (s, 9H, N*^{t}Bu*)
¹³C{¹H}-NMR (C₆D₆, 75 MHz, 300 K): 133,0 (*η³-all*), 102,3 (CH-D^{t}BuAD), 68,8 (*η³-all* ), 65,4 (N*C*Me₃), 56,2 (*C*Me₃-D^{t}BuAD), 34,4 (NC*Me₃*), 31,8 (C*Me₃*-D^{t}BuAD)
IR (KBr, cm⁻¹): 3065(w), 3027(m), 1628(w), 1501(m), 1456(s), 1389(m), 1360(s), 1281(s), 1248(w), 1221(s), 1150(m), 1109(w), 1063(w), 1016(w), 1003(m), 961(w), 866(m), 841(s), 808(m), 768(s), 723(w), 694(w), 629(w), 563(w).

### Beispiel 18: Herstellung einer erfindungsgemäßen Ta-haltigen CVD-Schicht

Nach üblicher Vorbehandlung wurde eine Si-Scheibe (Hersteller: Wacker oder Virginia Semiconductor) in eine CVD-Apparatur (Typ Aix 200 des Herstellers Aixtron AG) eingesetzt. Zunächst erfolgte in üblicher Weise ein thermischer Ausheizschritt der Si-Scheibe zu Reinigungszwecken bei 750°C in einem inerten Trägergasstrom. Danach wurde die Scheibe auf eine Substrattemperatur von 350°C abgekühlt. Auf die so erhaltene Oberfläche wurde eine Schicht aus den erfindungsgemäßen Ta-Ausgangssubstanzen abgeschieden. Hierzu wurde ein Inertgasstrom aus N₂ mit den verschiedenen Edukten beladen. Als Edukte wurden eingesetzt: (DAD)(^{t}BuN)Ta(BH₄) und 1,1-Dimethylhydrazin, wobei das 1,1-Dimethylhydrazin kommerziell in der für die CVD geeigneten Reinheit erhältlich ist (beispielsweise von Akzo Nobel HPMO).

Für die Herstellung erfindungsgemäßer Ta-haltiger Schichten wurden beispielhaft die folgenden Bedingungen bei einem Gesamtdruck des CVD-Reaktors von 100 hPa gewählt: 0,0005 hPa (DAD)(^{t}BuN)Ta(BH₄), 3 hPa 1,1-Dimethylhydrazin. Das N/Ta-Verhältnis wurd somit zu 6000 gewählt. Der beladene N₂-Trägergasstrom mit einem Gesamtdruck von 100 hPa wurde sodann für die Dauer von 1 h über die auf 350°C erwärmte Oberfläche der Si-Scheibe geleitet. Es wurde eine erfindungsgemäße Schicht mit einer Dicke von 145 nm erhalten. Nach Ablauf der Expositionsdauer wurde die CVD-Anlage auf die Abscheidebedingungen einer gewünschten weiteren Schicht umgestellt, oder die Schicht wurde unter einem inerten Trägergasstrom abgekühlt und dem CVD-Reaktor entnommen.

### Beispiel 19: Herstellung von (D^{t}BuAD)(^{t}BuN)NbCl als Pyridin-Komplex

Zu einer Lösung von 5,0 g (11,7 mmol) tBuN=NbCl₃2Py (hergestellt nach Lit. J. Sundermeyer, J. Putterlik, M. Foth, J. S. Field, N. Ramesar, Chem. Ber. 1994, 127, 1201-1212) in 20 ml THF wurde eine Lösung von 2,1 g (11,7 mmol) Li₂D^{t}BuAD aus Vorprodukt-Beispiel A in 20 ml THF bei -80°C zugetropft. Nach 30 min Rühren wurde das dunkelbraune Reaktionsgemisch erwärmt und für weitere 10 h bei 23°C gerührt. Nach Abdestillieren aller flüchtigen Bestandteile wurde der Rückstand zweimal mit je 10 ml Diethylether extrahiert. Die Etherphasen wurden vereinigt, der Ether abdestilliert und der gelbe Rückstand mit 20 ml Hexan gewaschen. Ausbeute 3,8 g (72 % d. Th.), Schmp. 115,4°C.

| Elementaranalyse: | | | |
|---|---|---|---|
| Ber. (%) für C₁₉H₃₄N₄ClNb (*M*= 446,87 g·mol⁻¹): | C 51,07; | H 7,67; | N 12,54 |
| Gef. (%): | C 49,26; | H 7,64; | N 11,84 |

MS-EI: 367 (M⁺ ― Py, 30 %), 352 (M⁺ ― Py ― Me, 46 %), 296 (M⁺ ― Py ― Me₂C=CH₂ ― Me, 3 %), 240 (M⁺―Py―Me―2·Me₂C=CH₂, 2 %), 199 (M⁺―Py―3·Me₂C=CH₂, 13 %), 57 (100 %).
¹H-NMR (δ gegen TMS, C₆D₆, 300 MHz, 300 K): 8,53 (pseudo-d, ³J_{HH} = 3,6 Hz, 2H, o-*Py*), 6,79 (pseudo-t, ³J_{HH} = 7,6 Hz, 1H, p*-Py),* 6,47 (pseudo-t, ³J_{HH} = 6,3 Hz, 2H, m-*Py*), 6,17 (breites s, 2H, C*H*-D^{t}BuAD), 1,52 (s, 9H, *^{t}Bu*N), 1,35 (breites s, 18H, *^{t}Bu*-D^{t}BuAD)
¹H-NMR (δ gegen TMS, d₈-Toluol, 100MHz, 230K): 8,39 (dd, ³J_{HH} = 6,4Hz, ⁴J_{HH} = 1,5Hz, 2H, o-*Py*), 6,69 (tt, ³J_{HH} = 7,6Hz, ⁴J_{HH} = 1,5Hz, 1H, p-*Py*), 6,38 - 6,35 (m, 3H, m-*Py* überlappend mit C*H*-D^{t}BuAD), 5,82 (d, 1H, ³J_{HH} = 3,5 Hz, C*H*-D^{t}BuAD), 1,64 (s, 9H, *^{t}Bu*-D^{t}BuAD), 1,51 (s, 9H, *^{t}Bu*N), 0,96 (breites s, 9H, *^{t}Bu*-D^{t}BuAD).
¹³C{¹H}-NMR (C₆D₆, 75 MHz, 300 K): 150,6, 136,9 und 123,7 *(Py),* 57,3 (CMe₃-D^{t}BuAD), 32,9 (NC*Me₃*), 30,7 (C*Me₃*-D^{t}BuAD).
¹³C{¹H}-NMR (d₈-Toluol, 400 MHz, 230 K): 150,1, 137,7 und 123,9 *(Py),* 110,3 und 101,2 (*C*H-D^{t}BuAD), 67,0 (N*C*Me₃), 57,0 und 56,6 (*C*Me₃-D^{t}BuAD), 32,7 (NC*Me₃*), 30,5 und 30,2 (C*Me₃*-D^{t}BuAD).
IR (KBr, cm⁻¹): 3020(w), 1602(w), 1480(w), 1360(m), 1353(w), 1258(m), 1244(m), 1217(s), 1155(w), 1138(w), 1057(w), 1045(w), 1012(w), 875(m), 814(m), 775(m), 761(m), 723(w), 700(m), 634(w).

### Beispiel 20: Herstellung von (D^{t}BuAD)Nb(N^{t}Bu)(BH₄)

1,6 g (4,35 mmol, als monomere Verbindung gerechnet) [(D^{t}BuAD)(^{t}BuN)Nb(µ-Cl)]₂ aus Vorprodukt Beispiel E und 0,37 g NaBH₄ (9,78 mmol) wurden in 50 ml THF suspendiert und bei 23°C 12 h gerührt. Das Lösungsmittel bei 20 mbar abdestilliert und der Rückstand bei 60 °C/10⁻⁴ mbar sublimiert. Die Sublimation ergab 0,95 g (67 %d. Th.) gelbes, festes Produkt vom Schmp 65,4°C.

| Elementaranalyse: | | | |
|---|---|---|---|
| Ber. (%) für C₁₄H₃₃BN₃Nb (*M*= 347,16 g mol⁻¹): | C 48,44; | H 9,58; | N 12,10 |
| Gef. (%): | C 47,88; | H 9,56; | N 12,11 |

MS-EI: 347 (M⁺, 100 %), 332 (M⁺ ― Me, 8 %), 318 (M⁺ - Me - BH₃, 13 %), 276 (M⁺ - Me₂C=CH₂ ― Me, 42 %).
¹H-NMR (d₈-Toluol, 500 MHz, 300 K): 5,87 (s, 2H, *CH*-D^{t}BUAD), 1,31 (s, 9H, N*^{t}Bu*), 1,19 (s, 18H, *^{t}Bu*-D^{t}BuAD), 0,04 (q, 4H, ¹J_{BH} = 85 Hz, B*H₄*).
¹³C{¹H)-NMR (C₆D₆, 75 MHz, 300 K): 107,8 (*C*H-D^{t}BuAD), 33,1 (NC*Me₃*), 31,6 (C*Me₃*-D^{t}BuAD). ¹¹B-NMR (d₈-Toluol, 160 MHz, 300 K): -21,3 (quint, ¹J_{BH} = 85 Hz, *B*H₄).
IR (KBr, cm⁻¹): 3032(w), 2507(s), 2319(w), 2274(w), 2099(w), 2037(s), 1495(w), 1456(s), 1390(w), 1364(s), 1302(w), 1258(s), 1217(s), 1157(s), 1140(w), 1111(w), 1061(w), 1026(w), 1017(w), 947(w), 876(s), 816(s), 777(s), 723(w), 567(w), 516(w), 513(w), 494(w), 449(w).

### Beispiel 21: Herstellung von (D^{t}BuAD)Nb(N^{t}Bu)(NH^{t}Bu)

Zu einer Suspension von 50,0 g NbCl₅ (185 mmol) in 300 ml Toluol wurden 225 ml tert.Butylamin (2,15 mol) unter Eiskühlung zugetropft. Nach 8 h Rühren bei 23°C wurde die gelbe Lsg. filtriert und das Lösungsmittel bei 20 mbar abgezogen. Das ölige Zwischenprodukt wurde ohne weitere Reinigung in 250 ml THF gelöst, hierzu wurden 31,2 g (185 mmol) D^{t}BuAD, gefolgt von 4,5 g Mg-Pulver (185 mmol) zugegeben. Das Reaktionsgemisch wurde 12 h bei 23°C gerührt, danach wurde das Lösungsmittel bei 20 mbar abgezogen. Die zweimalige Extraktion des Rückstandes mit je 250 ml Hexan ergab ein gelbes, öliges Rohprodukt, das durch Sublimation bei 100°C710⁻⁴ mbar gereinigt wurde. Ausbeute 30,8 g (41 % d. Th.), Schmp. 70,6°C.

| Elementaranalyse: | | | |
|---|---|---|---|
| Ber. (%) für C₁₈H₃₉N₄Nb (*M*= 404,44 g mol⁻¹): | C 53,46; | H 9,72; | N 13,85. |
| Gef. (%): | C 52,87; | H 9,59; | N 13,56. |

MS-EI: 404 (M⁺, 22 %);389 (M⁺-Me, 10 %), 332 (M⁺ ― CH₃CNH, 4 %),57 (100 %).
¹H-NMR (C₆D₆, 300 MHz, 300 K): 5,86 (s, 2H, C*H*-D^{t}BuAD), 4,10 (s, 1H, N*H*), 1,54 (s, 9H, N*^{t}Bu*), 1,33 (s, 18H, *^{t}Bu*-D^{t}BuAD), 1,26 (s, 9H, NH*^{t}Bu*).
¹³C{¹H}-NMR (C₆D₆, 75 MHz, 300 K): 104,2 (C*H*-D^{t}BuAD), 64,0 (NCMe₃), 55,7 (CMe₃-D^{t}BuAD), 53,4 (NHCMe₃), 35,1 (NC*Me₃*), 34,1 (NHC*Me₃*), 31,9 (C*Me₃*-D^{t}BuAD).
IR (KBr, cm⁻¹): 3021(w), 1456(w), 1389(w), 1361(m), 1260(s), 1242(w), 1221(s), 1148(w), 1136(w), 1107(w), 1064(w), 1024(w), 980(w), 950(w), 870(w), 814(w), 771(w), 754(w), 592(w), 572(w),515(w).

## Patentansprüche

1. Verbindungen der allgemeinen Formel (I) 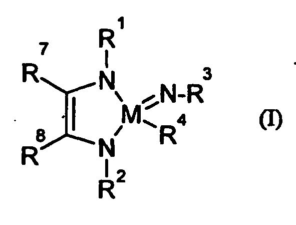 wobei
M für Ta oder Nb steht,
R¹ und R² unabhängig voneinander ggf. substituierte C₁- bis C₁₂-Alkyl-, C₅- bis C₁₂-Cycloalkyl- oder C₆- bis C₁₀-Aryl-Reste, 1-Alkenyl-, 2-Alkenyl-, 3-Alkenyl oder Triorganosilylreste -SiR₃, oder Aminoreste NR₂ wobei R für einen C₁- bis C₄-Alkylrest steht,
R³ einen ggf. substituierten C₁- bis C₈-Alkyl-, C₃- bis C₁₀-Cycloalkyl-, C₆- bis C₁₄-Aryl-Rest, oder SiR₃, oder NR₂ wobei R die oben angegebene Bedeutung hat,
R⁴ Halogen aus der Gruppe Cl, Br, J, oder NH-R⁵ mit R⁵ = ggf. substituierter C₁- bis C₈-Alkyl-, C₅- bis C₁₀-Cycloalkyl- oder C₆- bis C₁₀-Aryl-Rest, oder O-R⁶ mit R⁶ = ggf. substituierter C₁- bis C₁₁-Alkyl-, C₅- bis C₁₀-Cycloalkyl- oder C₆- bis C₁₀-Aryl-Rest, oder -SiR₃, oder BH₄, oder ein ggf. substituierter Allyl-Rest; oder ein Indenyl-Rest, oder ein ggf. substituierter Benzyl-Rest, oder ein ggf. substituierter Cyclopentadienyl-Rest, oder NR-NR'R" (Hydrazido(-1), wobei R, R' und R" unabhängig voneinander die oben genannte Bedeutung von R haben, oder CH₂SiMe₃, Pseudohalogenid (z.B. -N₃), oder Silylamid N(SiMe₃)₂,
R⁷ und R⁸ unabhängig voneinander H, ggf. substituierte C₁- bis C₁₂-Alkyl-, C₅- bis C₁₂-Cycloalkyl- oder C₆- bis C₁₀-Aryl-Reste bedeuten.

2. Verbindungen nach Anspruch 1, **dadurch gekennzeichnet, dass** sie der allgemeinen Formel II entsprechen, 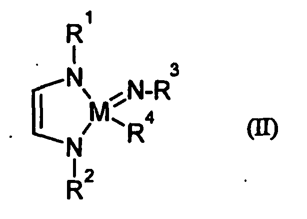 wobei
M fiir Ta oder Nb steht,
R¹ und R² gleiche C₁- bis C₅-Alkyl- oder C₅- bis C₆-Cycloalkyl-Reste,
R³ einen C₁- bis C₅-Alkyl-, C₅- bis C₆-Cycloalkyl- oder ggf. substituierten Phenyl-Rest,
R⁴ ein Halogen aus der Gruppe Cl, Br, J, einen Rest NH-R⁵ mit R⁵ = C₁- bis C₅-Alkyl-, C₅- bis C₆-Cycloalkyl- oder ggf. substituierten C₆- bis C₁₀-Aryl-Rest, oder BH₄, oder einen ggf. substituierter Allyl-Rest, oder einen ggf. substituierten Benzyl-Rest, oder einen ggf. substituierten Cyclopentadienyl-Rest oder einen Oxyalkyl-Rest bedeuten.

3. Verbindungen nach Anspruch 1, **dadurch gekennzeichnet, dass** sie der allgemeinen Formel (III) entsprechen, 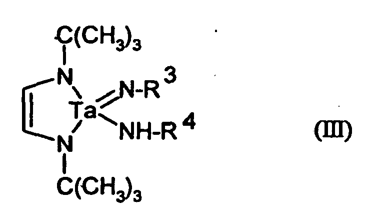 wobei
R³ und R⁴ unabhängig voneinander einen gleichen oder verschiedenen Rest aus der Gruppe der C₁- bis C₅-Alkyl-Reste bzw. der, ggf. durch eine bis drei C₁ bis C₅-Alkylgruppen substituierten, C₆- C₁₀-Arylreste bedeuten.

4. Verbindungen nach Anspruch 2, **dadurch gekennzeichnet, dass** sie ausgewählt sind aus der Gruppe:

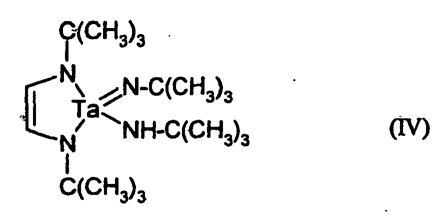

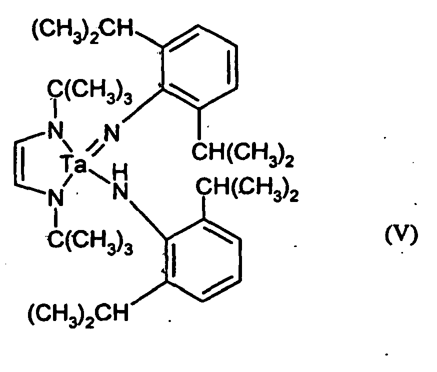

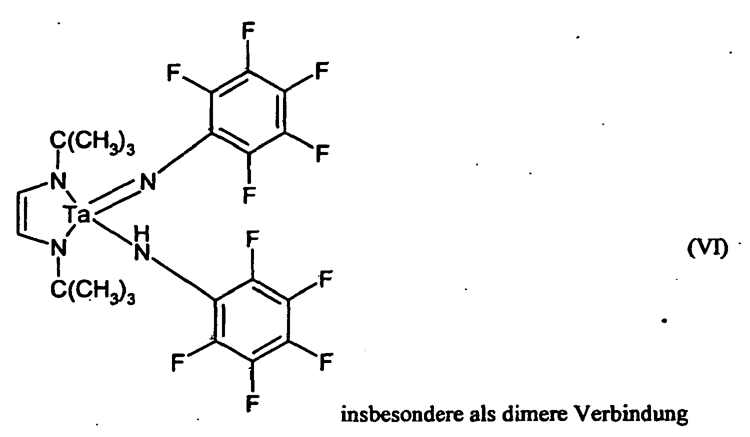

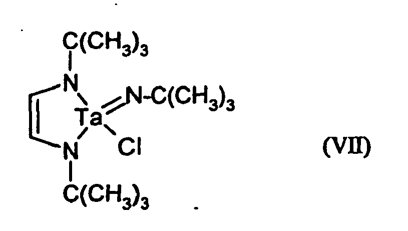

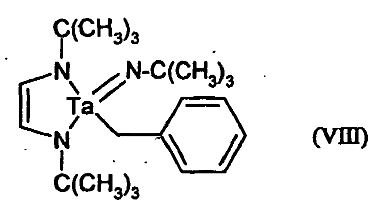

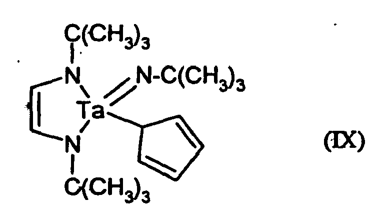

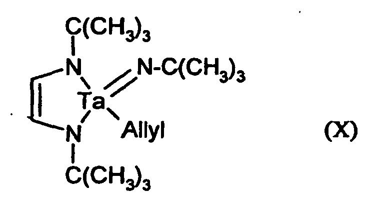

5. Verbindungen nach Anspruch 2, **dadurch gekennzeichnet, dass** sie der allgemeinen Formel (XI) entsprechen, 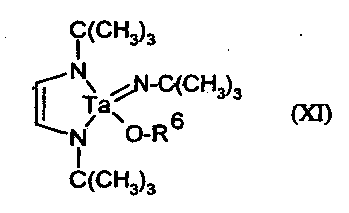 wobei R⁶ einen ggf. substituierten C₁- bis C₁₂-Alkyl-Rest bedeutet.

6. Verbindung nach Anspruch 5, **dadurch gekennzeichnet, dass** sie der Struktur (XII) entspricht.

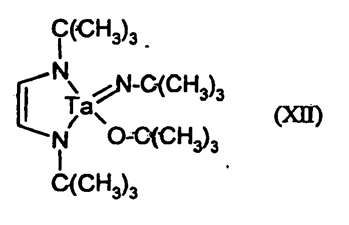

7. Verbindungen nach Anspruch 2, **dadurch gekennzeichnet, dass** sie der allgemeinen Formel (XIII) entsprechen, 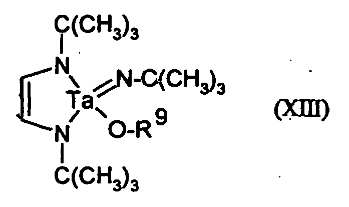 wobei
R⁹ einen Rest eines Enolats der Formel XIV, 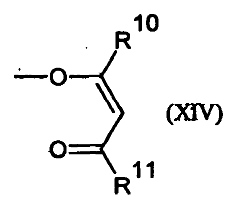 in dem
R¹⁰ einen C¹- bis C⁴-Alkylrest bedeutet und R¹¹ gleich R¹⁰ oder unabhängig voneinander OR¹⁰ ist, bedeutet.

8. Verwendung von Tantal-Verbindungen gemäß den Ansprüchen 1 bis 7 als Vorläuferverbindung (Prekursor) fiir die Herstellung Tantal-haltiger Schichten mittels des Chemical Vapour Deposition-Verfahrens.

9. Verwendung von Tantal-Verbindungen gemäß den Ansprüchen 1 bis 7 als Vorläuferverbindung (Prekursor) für die Herstellung für Tantalnitrid-(TaN)-schichten mittels des Chemical Vapour Deposition-Verfahrens.

10. Verwendung von Niob-Verbindungen gemäß den Ansprüchen 1 bis 2 als Prekursor für die-Herstellung Niob-haltiger Schichten mittels des Chemical Vapour Deposition-Verfahrens.

11. Verwendung von Niob-Verbindungen gemäß den Ansprüchen 1 bis 2 als Prekursor für die Herstellung Niob-haltiger Schichten Niobnitrid-(NbN)-schichten mittels des Chemical Vapour Deposition-Verfahrens.

12. Gemäß Anspruch 8 oder 9 hergestellte Tantal-haltige Schichten, bevorzugt TaN-Schichten.

13. Substrate aufweisend eine Tantal-haltige, bevorzugt TaN-Schicht hergestellt aus einer Verbindung gemäß einem der Ansprüche 1 bis 7.

14. Gemäß Anspruch 10 oder 11 hergestellte Niob-haltige Schichten, bevorzugt NbN-Schichten.

15. Substrate aufweisend eine Niob-haltige, bevorzugt NbN-Schicht hergestellt aus einer Verbindung gemäß einem der Ansprüche 1 bis 2.

## Claims

1. Compounds having the general formula (I) 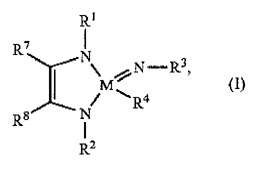 wherein
M stands for Ta or Nb,
R¹ and R² mutually independently denote optionally substituted C₁ to C₁₂ alkyl, C₅ to C₁₂ cycloalkyl or C₆ to C₁₀ aryl radicals, 1-alkenyl, 2-alkenyl, 3-alkenyl or triorganosilyl radicals -SiR₃, or amino radicals NR₂ wherein R stands for a C₁ to C₄ alkyl radical,
R³ denotes an optionally substituted C₁ to C₈ alkyl, C₅ to C₁₀ cycloalkyl, C₆ to C₁₄ aryl radical, or SiR₃, or NR₂ wherein R has the aforementioned meaning,
R⁴ denotes halogen from the group comprising Cl, Br, I, or NH-R⁵ where R⁵=optionally substituted C₁ to C₈ alkyl, C₅ to C₁₀ cycloalkyl or C₆ to C₁₀ aryl radical, or O-R⁶ where R⁶ = optionally substituted C₁ to C₁₁ alkyl, C₅ to C₁₀ cycloalkyl or C₆ to C₁₀ aryl radical, or -SiR₃, or BH₄, or an optionally substituted allyl radical, or an indenyl radical, or an optionally substituted benzyl radical, or an optionally substituted cyclopentadienyl radical, or -NR-NR'R " (hydrazido(-1), wherein R, R' and R" mutually independently have the aforementioned meaning of R, or CH₂SiMe₃, pseudohalide (e.g. -N₃), or silylamide -N(SiMe₃)₂,
R⁷ and R⁸ mutually independently denote H, optionally substituted C₁ to C₁₂ alkyl, C₅ to C₁₂ cycloalkyl or C₆ to C₁₀ aryl radicals.

2. Compounds according to Claim 1, **characterized in that** they correspond to the general formula II, 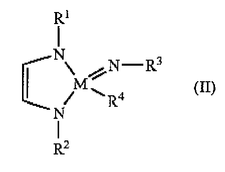 wherein
M stands for Ta or Nb,
R¹ and R² denote identical C₁ to C₅ alkyl or C₅ to C₆ cycloalkyl radicals,
R³ denotes a C₁ to C₅ alkyl, C₅ to C₆ cycloalkyl or optionally substituted phenyl radical,
R⁴ denotes a halogen from the group comprising Cl, Br, I, a radical NH-R⁵ where R⁵=C₁ to C₅ alkyl, C₅ to C₆ cycloalkyl or optionally substituted C₆ to C₁₀ aryl radical, or BH₄, or an optionally substituted allyl radical, or an optionally substituted benzyl radical, or an optionally substituted cyclopentadienyl radical or an oxyalkyl radical.

3. Compounds according to Claim 1, **characterized in that** they correspond to the general formula (III), 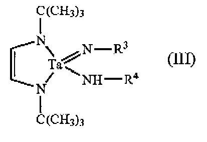 wherein
R³ and R⁴ mutually independently denote an identical or different radical from the group of C₁ to C₅ alkyl radicals, or C₆ to C₁₀ aryl radicals optionally substituted by one to three C₁ to C₅ alkyl groups.

4. Compounds according to Claim 2, **characterized in that** they are selected from the group consisting of:

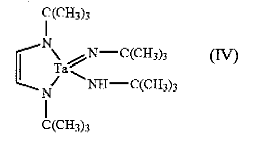

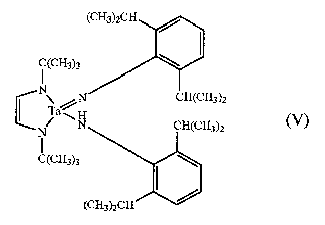

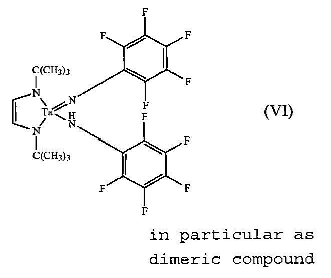

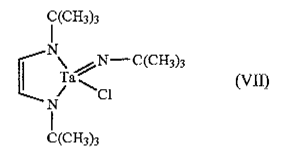

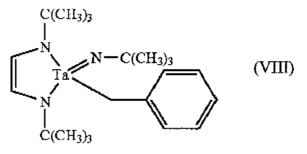

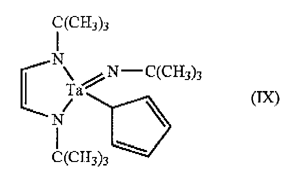

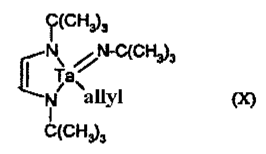

5. Compounds according to Claim 2, **characterized in that** they correspond to the general formula (XI), 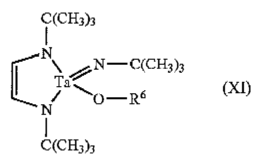 wherein R⁶ denotes an optionally substituted C₁ to C₁₂ alkyl radical.

6. Compound according to Claim 5, **characterized in that** it corresponds to the structure (XII):

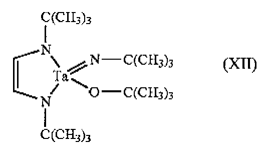

7. Compounds according to Claim 2, **characterized in that** they correspond to the general structure (XIII), 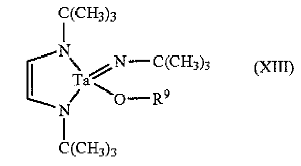 wherein
R⁹ denotes a radical of an enolate having the formula (XIV), 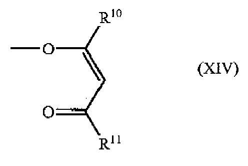 in which
R¹⁰ denotes a C₁ to C₄ alkyl radical and R¹¹ is the same as R¹⁰ or mutually independently denotes OR¹⁰.

8. Use of tantalum compounds according to Claims 1 to 7 as a precursor for the production of tantalum-containing layers by the chemical vapour deposition process.

9. Use of tantalum compounds according to Claims 1 to 7 as a precursor for the production of tantalum nitride (TaN) layers by means of the chemical vapour deposition process.

10. Use of niobium compounds according to Claims 1 to 2 as a precursor for the production of niobium-containing layers by means of the chemical vapour deposition process.

11. Use of niobium compounds according to Claims 1 to 2 as a precursor for the production of niobium nitride (NbN) layers by means of the chemical vapour deposition process.

12. Tantalum-containing layers, preferably TaN layers, produced according to Claim 8 or 9.

13. Substrates comprising a tantalum-containing, preferably TaN, layer produced from a compound according to any one of Claims 1 to 7.

14. Niobium-containing layers, preferably NbN layers, produced according to Claim 10 to 11.

15. Substrates comprising a niobium-containing, preferably NbN, layer produced from a compound according to any one of Claims 1 to 2.

## Revendications

1. Composés de la formule générale (I) 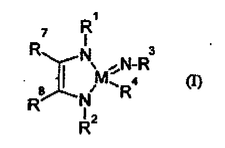 dans laquelle
M désigne Ta ou Nb,
R¹ et R² désignent, indépendamment l'un de l'autre, des radicaux, le cas échéant, substitués, C₁- à C₁₂-alkyle, C₅- à C₁₂-cycloalkyle, ou C₆- à C₁₀-aryle, 1-alcényle, 2-alcényle, 3-alcényle ou des radicaux triorganosilyles - SiR₃ ou des radicaux amino NR₂, R représentant un radical C₁- à C₄-alkyle,
R³ désigne un radical, le cas échéant, substitué, C₁-à C₈-alkyle, C₅- à C₁₀-cycloalkyle, C₆- à C₁₄-aryle ou SiR₃, ou NR₂, R ayant la signification indiquée plus haut,
R⁴ désigne un halogène du groupe Cl, Br, J ou NH-R⁵ avec R⁵ = un radical, le cas échéant, substitué, C₁- à C₈-alkyle, C₅- à C₁₀-cycloalkyle, ou C₆- à C₁₀-aryle, ou O-R⁶ avec R⁶ = un radical, le cas échéant, substitué, C₁- à C₁₁-alkyle, C₅- à C₁₀-cycloalkyle ou C₆- à C₁₀-aryle, ou SiR₃, ou BH₄, ou un radical allyle, le cas échéant, substitué, ou un radical indényle, ou un radical benzyle, le cas échéant, substitué, ou un radical cyclopentadiényle, le cas échéant, substitué ou NR-NR'R " (hydrazido(-1), R, R' et R" ayant, indépendamment les uns des autres, la signification suscitée de R, ou un radical CH₂SiMe₃, pseudohalogénure (par exemple -N₃) ou silylamide -N(SiMe₃)₂,
R⁷ et R⁸ signifient, indépendamment l'un de l'autre, des radicaux, le cas échéant, substitués, C₁- à C₁₂-alkyle, C₅- à C₁₂-cycloalkyle ou C₆- à C₁₀-aryle.

2. Composés selon la revendication 1, **caractérisés en ce qu'**ils correspondent à la formule générale II 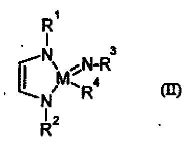 dans laquelle
M désigne Ta ou Nb,
R¹ et R² signifient des radicaux identiques C₁- à C₅-alkyle ou C₅- à C₆-cycloalkyle,
R³ désigne un radical C₁- à C₅-alkyle, C₅- à C₆-cycloalkyle ou un radical phényle, le cas échéant, substitué,
R⁴ désigne un halogène du groupe Cl, Br, J, un radical NH-R⁵ avec R⁵ = un radical C₁- à C₅-alkyle, C₅- à C₆-cycloalkyle ou C₆- à C₁₀-aryle, le cas échéant, substitué, ou BH₄, ou un radical allyle, le cas échéant, substitué, ou un radical benzyle, le cas échéant, substitué, ou un radical cyclopentadiényle, le cas échéant, substitué ou un radical oxyalkyle.

3. Composés selon la revendication 1, **caractérisé en ce qu'**ils correspondent à la formule (III) générale 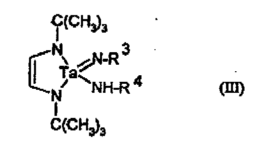 dans laquelle
R³ et R⁴ désignent, indépendamment l'un de l'autre, un radical identique ou différent, choisi parmi le groupe des radicaux C₁- à C₅-alkyle ou des radicaux C₆-C₁₀-aryles, le cas échéant, substitués par de un à trois groupements C₁- à C₅-alkyles.

4. Composés selon la revendication 2, **caractérisés en ce qu'**ils sont sélectionnés parmi le groupe : 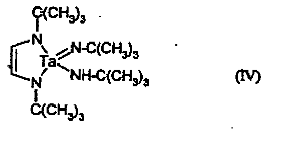 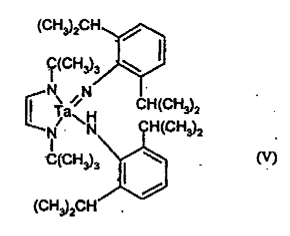 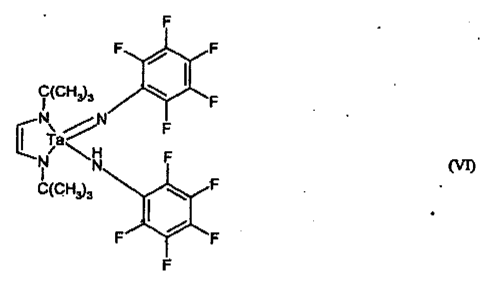 en particulier, en tant que composé binaire,

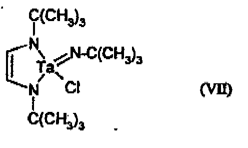

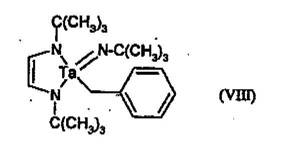

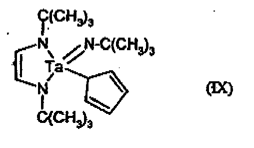

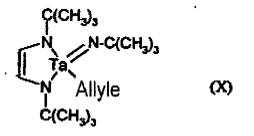

5. Composés selon la revendication 2, **caractérisé en ce qu'**ils correspondent à la formule générale (XI) 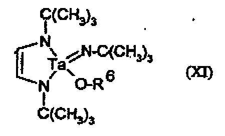 dans laquelle R⁶ désigne un radical, le cas échéant, substitué, C₁- à C₁₂-alkyle.

6. composé selon la revendication 5, **caractérisé en ce qu'**il correspond à la structure (XII)

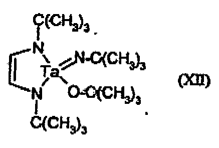

7. Composés selon la revendication 2, **caractérisés en ce qu'**ils correspondent à la formule générale (XIII) 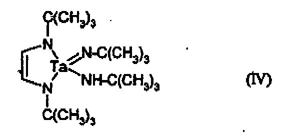 dans laquelle
R⁹ désigne un radical d'un énolate de la formule XIV 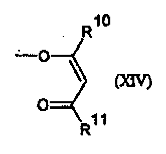 dans laquelle
R¹⁰ signifie un radical C₁- à C₄-alkyle et R¹¹ est identique à R¹⁰ ou, indépendamment l'un de l'autre, est OR¹⁰.

8. Utilisation de composés du tantale selon l'une quelconque des revendications 1 à 7, en tant que composé précurseur (précurseur) en vue de la fabrication de couches contenant du tantale à l'aide du procédé Chemical Vapour-Deposition.

9. Utilisation de composés du tantale selon l'une quelconque des revendications 1 à 7, en tant que composé précurseur (précurseur) en vue de la fabrication de couches en nitrure de tantale (TaN) à l'aide du procédé Chemical Vapour Deposition.

10. Utilisation de composés du niobium selon l'une quelconque des revendications 1 à 2, en tant que composé précurseur en vue de la fabrication de couches contenant du niobium à l'aide du procédé Chemical Vapour Deposition.

11. Utilisation de composés du niobium selon l'une quelconque des revendications 1 à 2, en tant que composé précurseur en vue de la fabrication de couches contenant du niobium, des couches en nitrure de niobium (NbN) à l'aide du procédé Chemical Vapour Deposition.

12. Couches contenant du tantale, fabriquées selon la revendication 8 ou 9, de préférence, couches de TaN.

13. Substrat présentant une couche contenant du tantale, de préférence, une couche de TaN, fabriquée à partir d'un composé selon l'une quelconque des revendications 1 à 7.

14. Couches contenant du niobium, de préférence, couches de NbN, fabriquées selon la revendication 10 ou 11.

15. Substrat présentant une couche contenant du niobium, de préférence, une couche NbN, fabriquée à partir d'un composé selon l'une quelconque des revendications 1 à 2.
